# EUROPEAN PATENT SPECIFICATION

(11) **EP 4 432 368 B1**
(45) Date of publication and mention of the grant of the patent: **21.10.2026**
(21) Application number: 22906944.8
(22) Date of filing: 09.09.2022
(51) Int. Cl.: H10F 77/00, H10F 39/00, H10F 77/50, H10W 72/00, H10W 72/50, H10W 72/90, H10W 90/00, H10P 72/70

(54) **OPTICAL SEMICONDUCTOR PACKAGE AND METHOD FOR PRODUCING OPTICAL SEMICONDUCTOR PACKAGE**
OPTISCHES HALBLEITERGEHÄUSE UND VERFAHREN ZUR HERSTELLUNG EINES OPTISCHEN HALBLEITERGEHÄUSES
BOÎTIER DE SEMI-CONDUCTEUR OPTIQUE ET PROCÉDÉ DE PRODUCTION DE BOÎTIER DE SEMI-CONDUCTEUR OPTIQUE

(30) Priority: 13.12.2021 JP 2021201464
(43) Date of publication of application: 18.09.2024
(73) Proprietor: Hamamatsu Photonics K.K., Hamamatsu-shi, Shizuoka 435-8558 (JP)
(72) Inventor: INOUE, Nao, (deceased) (JP); SHIMAI, Shingo, Hamamatsu-shi, Shizuoka 435-8558 (JP); SUWA, Yosuke, Hamamatsu-shi, Shizuoka 435-8558 (JP); KOMATSU, Tatsuhiro, Hamamatsu-shi, Shizuoka 435-8558 (JP)
(74) Representative: Hoffmann Eitle
(86) International application number: PCT/JP2022/033940
(87) International publication number: WO 2023/112409

(56) References cited:
- WO-A1-2006/095834
- JP-A- 2005 286 284
- JP-A- 2005 311 397
- JP-A- 2008 226 895
- JP-A- 2011 014 839
- JP-A- 2011 014 839
- JP-A- 2016 062 985
- JP-A- 2017 130 586
- JP-A- H10 144 939
- US-A1- 2004 028 352
- US-A1- 2008 179 503
- US-A1- 2013 049 205
- US-A1- 2017 117 252

## Description

### Technical Field

The present disclosure relates to an optical semiconductor package and a method for producing an optical semiconductor package.

### Background Art

Patent Literature 1 discloses a package structure including a semiconductor chip as an optical sensor and a molding resin covering the semiconductor chip. In the package structure, reliability of the package structure is enhanced by protecting the semiconductor chip with the molding resin.

US 2004/028352 A1 discloses an optical module comprising an optical fiber; an optical element having an optical section and with a fixed position relative to the optical fiber; and a semiconductor chip electrically connected to the optical element, and the optical element and semiconductor chip being packaged. A hole is formed in the semiconductor chip, and the optical element is mounted on the semiconductor chip with the optical section facing the hole, and the optical fiber is inserted in the hole and fitted to the semiconductor chip.

JP 2011 014839 A discloses an optical semiconductor device that has the optical-sensor chip formed of a silicon material to detect the visible light incident from one surface side of the chip; the infrared-sensor chip disposed in the thickness direction of the sensor chip, to detect the infrared light incident from one surface of the sensor chip and transmitted to another surface; a glass epoxy resin substrate (basic body) with the infrared-sensor chip mounted thereon; and a sealing resin to seal part of the optical-sensor chip, the infrared-sensor chip, and the glass epoxy resin substrate.

### Citation List

### Patent Literature

Patent Literature 1: Japanese Unexamined Patent Publication No. 2016-134615

### Summary of Invention

### Technical Problem

The package structure disclosed in Patent Literature 1 includes only one semiconductor chip. However, as a structure of an optical semiconductor package including a semiconductor chip such as a light receiving sensor, there is also a stacked structure in which two semiconductor chips are disposed to be stacked. In such a stacked structure, a package structure capable of securing high reliability is required.

An object of the present disclosure is to provide an optical semiconductor package and a method for producing an optical semiconductor package capable of improving reliability in a structure in which two semiconductor chips are disposed to be stacked.

### Solution to Problem

The present invention is defined by the appended claims. The aspects set out below are included for explanatory purposes and to facilitate understanding of the present disclosure; they do not by themselves define the subject-matter for which protection is sought.

An optical semiconductor package according to an aspect of the present disclosure includes a first chip being a semiconductor chip having a first inner surface, a first outer surface being a surface on an opposite side of the first inner surface, and a first side surface connecting the first inner surface and the first outer surface, a second chip being a semiconductor chip disposed at a position facing the first inner surface, the second chip having a second inner surface facing the first inner surface, a second outer surface being a surface on an opposite side of the second inner surface, and a second side surface connecting the second inner surface and the second outer surface, a first resin portion formed to cover at least the first side surface, a second resin portion formed to cover at least the second side surface, a first terminal being an electrode terminal of the first chip and provided on the first inner surface, a second terminal being an electrode terminal of the second chip and provided on the second inner surface, and a first wiring electrically connected to the first terminal, passing through an inside of the first resin portion, and extending from the first inner surface side to the first outer surface side in a facing direction in which the first inner surface and the second inner surface face each other. The second chip is an optical element having a light receiving portion which receives light incident on the second outer surface or a light emitting portion which generates light emitted from the second outer surface to an outside, and the first resin portion and the second resin portion are integrally provided or continuously provided via another member.

In the optical semiconductor package, the first resin portion and the second resin portion covering the side surfaces (first side surface and second side surface) of the first chip and the second chip disposed to be stacked in two stages are provided integrally or provided continuously via another member. That is, the first chip and the second chip are integrally fixed by the first resin portion and the second resin portion. Accordingly, the first chip and the second chip can be appropriately protected. In addition, the electrode terminals (first terminal and second terminal) of the first chip and the second chip are disposed in the region between the first chip and the second chip, and thus, the electrode terminals can be appropriately protected from external impact or the like. In addition, in a case where the electrode terminal (second terminal) of the second chip is provided on the outer surface (second outer surface) of the second chip, the following disadvantage may occur. That is, in a case where the second chip is the light receiving element having the light receiving portion, a part of light (that is, light to be detected by the light receiving portion) incident on the second outer surface may be reflected by the wiring or the like connected to the second terminal and routed to the second outer surface side, and this reflected light may be detected, as noise, by the light receiving portion. In addition, in a case where the second chip is the light emitting element having the light emitting portion, a part of the emitted light emitted from the second outer surface is reflected by the wiring or the like, and this reflected light may be output, as noise, to the outside. The second terminal of the second chip is provided on the second inner surface, and thus, the generation of noise described above can be prevented. As described above, according to the optical semiconductor package, the reliability (fastness and stability of light receiving function or light emitting function of second chip) of the optical semiconductor package can be improved in the structure in which two chips are disposed to be stacked.

The optical semiconductor package may further include an insulating layer covering the first outer surface of the first chip, and a contact portion provided to be exposed to an opposite side to the first chip side of the insulating layer, and electrically connected to the first terminal. According to the above configuration, the electrical contact with the first chip (first terminal) can be easily made via the contact portion.

The second resin portion may be made of a light transmissive resin, and the second outer surface may be covered with the second resin portion. According to the above configuration, since the second outer surface of the second chip can be appropriately protected by the second resin portion, the reliability of the optical semiconductor package can be enhanced. In addition, since it is not necessary to remove a part of the second resin portion formed on the second outer surface of the second chip by polishing or the like, the producing step can be simplified.

The second outer surface may not be covered with the second resin portion. According to the above configuration, since the incident light on the second outer surface or the emitted light from the second outer surface toward the outside is not blocked by the second resin portion provided on the second outer surface, the reliability of the light receiving function or the light emitting function of the second chip can be enhanced.

The second outer surface may be positioned closer to the first chip than a surface of the second resin portion on an opposite side to the first resin portion in the facing direction. According to the above configuration, since the second chip is thinned such that the second outer surface is positioned inside the outer surface of the second resin portion (the surface on the opposite side to the first resin portion), the amount of attenuation of light passing through the second chip can be reduced. Accordingly, the reliability of the light receiving function or the light emitting function of the second chip can be further enhanced.

The optical semiconductor package may further include a third terminal being an electrode terminal of the first chip and provided on the first inner surface, and a conductive member disposed between the first chip and the second chip to electrically connect the second terminal and the third terminal. According to the above configuration, the first chip and the second chip are conducted with each other in the region between the first chip and the second chip appropriately protected by the first resin portion and the second resin portion, and thus, the reliability of the optical semiconductor package can be enhanced.

The optical semiconductor package may further include a second wiring electrically connected to the second terminal, passing through the inside of the first resin portion, and extending from the first inner surface side to the first outer surface side in the facing direction. According to the above configuration, the second wiring routed from the second inner surface (second terminal) of the second chip to the first outer surface side of the first chip can be appropriately protected by the first resin portion. Accordingly, the reliability of the optical semiconductor package can be enhanced.

A width of the first chip may be smaller than or equal to a width of the second chip in a width direction orthogonal to the facing direction. In the optical semiconductor package, it is necessary to route the first wiring and the second wiring to the side of the first chip. Thus, in a case where the width of the first chip is larger than the width of the second chip, since the first wiring and the second wiring are positioned outside in the width direction by the width of the first chip, the size of the optical semiconductor package may be increased. On the other hand, the width of the first chip is equal to or smaller than the width of the second chip as described above, and thus, it is possible to suppress the increase in size of the optical semiconductor package described above. Further, a width of the first chip may be smaller than a width of the second chip in a width direction orthogonal to the facing direction, and the first wiring and the second wiring may be disposed in a region overlapping the second chip as viewed from the facing direction. According to the above configuration, since the first wiring and the second wiring can be accommodated in the region overlapping the second chip as viewed from the facing direction, a size of the optical semiconductor package in the width direction can be more compact. Accordingly, the optical semiconductor package can be downsized.

The second chip may be a first light receiving element having a first light receiving portion that receives light incident on the second outer surface, and the first chip may be a second light receiving element having a second light receiving portion that receives light transmitted through the second chip. According to the above configuration, the optical semiconductor package having the structure in which the light receiving elements are disposed to be stacked in two stages can be realized in a highly reliable manner.

A method for producing an optical semiconductor package according to a first aspect includes a first step of forming a substrate unit including a substrate and a first electrode and a second electrode provided on the substrate, a second step of forming a chip unit including the first chip and the second chip, the chip unit being in a state where the second terminal and the third terminal are electrically connected by the conductive member, a third step of mounting the chip unit on the substrate unit by bonding the first outer surface to the first electrode, a fourth step of forming the first wiring by wire-bonding the first terminal and the second electrode, a fifth step of integrally forming the first resin portion and the second resin portion, and a sixth step of removing the substrate.

A method for producing an optical semiconductor package according to a second aspect includes a first step of forming the first chip and the first resin portion in which a part of the first wiring is embedded, a second step of forming an insulating layer provided with the first wiring around the first terminal on the first inner surface and on the first resin portion, a third step of disposing the second chip on the first chip such that the second terminal and the third terminal are electrically connected by the conductive member, and a fourth step of forming the second resin portion after the third step.

A method for producing an optical semiconductor package according to a third aspect includes a first step of forming the first chip and the first resin portion in which a part of the first wiring and the second wiring is embedded, a second step of forming an insulating layer provided with the first wiring and the second wiring, on the first inner surface and the first resin portion, a third step of disposing the second chip on the insulating layer such that an end portion of the second wiring and the second terminal are electrically connected, and a fourth step of forming the second resin portion after the third step.

A method for producing an optical semiconductor package according to a fourth aspect includes a first step of forming a substrate, the first chip disposed on the substrate such that the first outer surface faces the substrate, the first resin portion formed to cover the first inner surface and the first side surface, and the first wiring and the conductive member disposed on the first resin portion and within the first resin portion, a second step of forming an insulating layer in which an opening for exposing the conductive member is provided, on the first resin portion, to cover the first wiring and the conductive member, a third step of disposing the second chip on the insulating layer such that the second terminal and the conductive member are electrically connected via the opening of the insulating layer, a fourth step of forming the second resin portion after the third step, and a fifth step of peeling off the substrate from the first chip and the first resin portion.

A method for producing an optical semiconductor package according to a fifth aspect includes a first step of forming a substrate, a second chip disposed on the substrate such that the second outer surface faces the substrate, the second resin portion formed to cover the second inner surface and the second side surface, and a first portion of the first wiring and the conductive member disposed on the second resin portion and within the second resin portion, a second step of forming an insulating layer in which a first opening and a second opening for making contact with the first portion and a third opening for making contact with the conductive member are provided, on the second resin portion, to cover the first portion and the conductive member, a third step of forming a second portion of the first wiring electrically connected to the first portion via the first opening on the insulating layer, a fourth step of disposing the first chip on the insulating layer such that the first terminal and the first portion are electrically connected via the second opening and such that the third terminal and the conductive member are electrically connected via the third opening, a fifth step of forming the first resin portion after the fourth step, and a sixth step of peeling off the substrate from the second chip and the second resin portion.

According to the method for producing an optical semiconductor package according to the first to fifth aspects, it is possible to easily obtain the optical semiconductor package with improved reliability in the structure in which two semiconductor chips are disposed to be stacked. In the method for producing an optical semiconductor package according to any one of the first to fifth aspects, the second resin portion may be formed not to cover the second outer surface. In addition, the above producing method may further include a step of removing a part on the second outer surface side of the second chip such that the second outer surface is positioned closer to the first chip than a surface of the second resin portion on an opposite side to the first resin portion.

### Advantageous Effects of Invention

According to the present disclosure, it is possible to provide the optical semiconductor package and the method for producing an optical semiconductor package capable of improving reliability in the structure in which two semiconductor chips are disposed to be stacked.

### Brief Description of Drawings

FIG. 1 is a sectional view of an optical semiconductor package of a first embodiment.
FIG. 2 is a diagram illustrating an example of a producing step of the optical semiconductor package of the first embodiment.
FIG. 3 is a diagram illustrating an example of the producing step of the optical semiconductor package of the first embodiment.
FIG. 4 is a diagram illustrating an example of the producing step of the optical semiconductor package of the first embodiment.
FIG. 5 is a diagram illustrating an example of the producing step of the optical semiconductor package of the first embodiment.
FIG. 6 is a sectional view of an optical semiconductor package of a first modification of the first embodiment.
FIG. 7 is a sectional view of an optical semiconductor package of a second modification of the first embodiment.
FIG. 8 is a diagram illustrating an example of a producing step of the optical semiconductor package of the second modification.
FIG. 9 is a sectional view of an optical semiconductor package of a third modification of the first embodiment.
FIG. 10 is a diagram illustrating an example of a producing step of the optical semiconductor package of the third modification.
FIG. 11 is a sectional view of an optical semiconductor package of a second embodiment.
FIG. 12 is a diagram illustrating an example of a producing step of the optical semiconductor package of the second embodiment.
FIG. 13 is a diagram illustrating an example of the producing step of the optical semiconductor package of the second embodiment.
FIG. 14 is a diagram illustrating an example of the producing step of the optical semiconductor package of the second embodiment.
FIG. 15 is a diagram illustrating an example of the producing step of the optical semiconductor package of the second embodiment.
FIG. 16 is a diagram illustrating an example of the producing step of the optical semiconductor package of the second embodiment.
FIG. 17 is a diagram illustrating an example of the producing step of the optical semiconductor package of the second embodiment.
FIG. 18 is a sectional view of an optical semiconductor package of a third embodiment.
FIG. 19 is a diagram illustrating an example of a producing step of the optical semiconductor package of the third embodiment.
FIG. 20 is a diagram illustrating an example of the producing step of the optical semiconductor package of the third embodiment.
FIG. 21 is a diagram illustrating an example of the producing step of the optical semiconductor package of the third embodiment.
FIG. 22 is a diagram illustrating an example of the producing step of the optical semiconductor package of the third embodiment.
FIG. 23 is a diagram illustrating an example of the producing step of the optical semiconductor package of the third embodiment.
FIG. 24 is a diagram illustrating an example of the producing step of the optical semiconductor package of the third embodiment.
FIG. 25 is a sectional view of an optical semiconductor package of a fourth embodiment.
FIG. 26 is a diagram illustrating an example of the producing step of the optical semiconductor package of the fourth embodiment.
FIG. 27 is a diagram illustrating an example of the producing step of the optical semiconductor package of the fourth embodiment.
FIG. 28 is a diagram illustrating an example of the producing step of the optical semiconductor package of the fourth embodiment.
FIG. 29 is a diagram illustrating an example of the producing step of the optical semiconductor package of the fourth embodiment.
FIG. 30 is a sectional view of an optical semiconductor package of a fifth embodiment.
FIG. 31 is a diagram illustrating an example of a producing step of the optical semiconductor package of the fifth embodiment.
FIG. 32 is a diagram illustrating an example of the producing step of the optical semiconductor package of the fifth embodiment.
FIG. 33 is a diagram illustrating an example of the producing step of the optical semiconductor package of the fifth embodiment.
FIG. 34 is a diagram illustrating an example of the producing step of the optical semiconductor package of the fifth embodiment.
FIG. 35 is a diagram illustrating an example of the producing step of the optical semiconductor package of the fifth embodiment.
FIG. 36 is a diagram illustrating a modification of the producing step of the optical semiconductor package of the first embodiment.

### Description of Embodiments

Hereinafter, embodiments of the present disclosure will be described with reference to the drawings. The same or corresponding parts in the drawings are denoted by the same reference signs, and repetitive descriptions will be omitted. Note that, in the drawings, there are some parts exaggerated for easy understanding of characteristic parts according to the embodiments. Thus, dimensional ratios in the drawings may be different from actual dimensional ratios.

### [First Embodiment]

### (Structure of Optical Semiconductor Package)

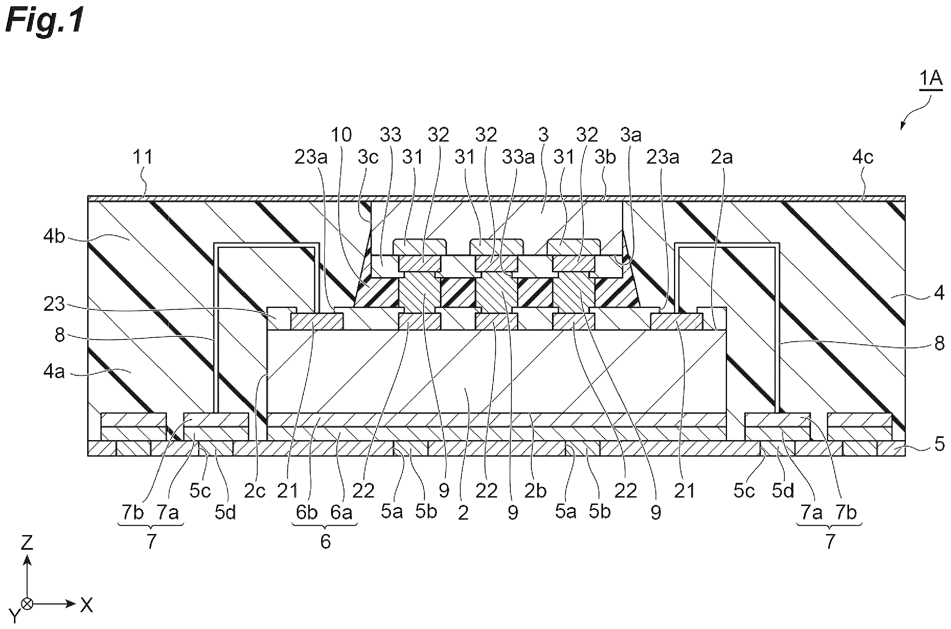

As illustrated in FIG. 1, an optical semiconductor package 1A of a first embodiment includes a first chip 2 (first semiconductor chip), a second chip 3 (second semiconductor chip), and a molding resin 4 (first resin portion 4a and second resin portion 4b). The second chip 3 is disposed to be stacked on the first chip 2. The molding resin 4 is formed to cover side surfaces of the first chip 2 and the second chip 3. The optical semiconductor package 1A is a type of Fan-Out Wafer-Level Package (FOWLP). In the present embodiment, as an example, the second chip 3 is a backside incidence type light receiving sensor (for example, linear image sensor, area image sensor, or the like), and the first chip 2 is a signal processing chip on which a circuit for processing a signal related to light detected by the second chip 3 which is the light receiving sensor is implemented.

The first chip 2 and the second chip 3 are formed in a rectangular plate shape. In FIG. 1, a facing direction in which the first chip 2 and the second chip 3 face each other is represented as a Z-axis direction, a direction along one side of the first chip 2 and the second chip 3 as viewed from the Z-axis direction is represented as an X-axis direction, and a direction along another side (a side perpendicular to the one side) of the first chip 2 and the third semiconductor chip as viewed from the Z-axis direction is represented as a Y-axis direction.

The first chip 2 is a semiconductor chip having an inner surface 2a (first inner surface), an outer surface 2b (first outer surface) which is a surface on an opposite side of the inner surface 2a, and a side surface 2c (first side surface) connecting the inner surface 2a and the outer surface 2b.

The outer surface 2b is disposed on an electrode 6 (first electrode) formed on an insulating layer 5. That is, the insulating layer 5 covers the outer surface 2b of the first chip 2 via the electrode 6. The electrode 6 includes a metal portion 6a provided on the insulating layer 5 and a plating portion 6b provided on the metal portion 6a. The outer surface 2b is bonded to the plating portion 6b via, for example, a die bonding resin or the like. A material of the metal portion 6a is, for example, aluminum (Al), copper (Cu), or the like. The plating portion 6b is, for example, three-layer plating (Ni/Pd/Au plating) of nickel (Ni), palladium (Pd), and gold (Au). The insulating layer 5 can be made of, for example, an inorganic film such as silicon dioxide (SiO₂) or silicon nitride (Si₃N₄). An opening 5a is provided in a portion of the insulating layer 5 overlapping the electrode 6. A plating portion 5b electrically connected to the metal portion 6a is provided within the opening 5a. The plating portion 5b is a portion bonded to a printed circuit board or the like by, for example, solder or the like. The plating portion 5b is, for example, two-layer plating (Ni/Au plating) of nickel and gold.

A plurality of terminals 21 (first terminals), a plurality of terminals 22 (third terminals), and an insulating layer 23 are provided on the inner surface 2a of the first chip 2.

The terminals 21 are electrode terminals for electrically connecting the first chip 2 and an external device (for example, a printed wiring board on which the optical semiconductor package 1A is mounted). In the present embodiment, electrodes 7 (second electrodes) electrically connected to the external device are provided at positions separated from the electrode 6 on the insulating layer 5. Similarly to the electrode 6, the electrode 7 includes a metal portion 7a provided on the insulating layer 5 and a plating portion 7b provided on the metal portion 7a. In addition, openings 5c are provided in portions of the insulating layer 5 overlapping the electrodes 7. A plating portion 5d (contact portion) electrically connected to the metal portion 7a is provided within the opening 5c. The plating portion 5d is provided to be exposed to an opposite side to the first chip 2 side of the insulating layer 5. Materials of the metal portion 7a, the plating portion 7b, and the plating portion 5d are similar to materials of the metal portion 6a, the plating portion 6b, and the plating portion 5b. The terminal 21 is electrically connected to the electrode 7 (plating portion 7b) via a wire 8 (first wiring). That is, the plating portion 7b is electrically connected to the terminal 21 via the electrode 7 and the wire 8. The wire 8 is formed by wire bonding. The wire 8 is electrically connected to the terminal 21, passes through an inside of the first resin portion 4a (a portion of the molding resin 4 covering the side surface 2c of the first chip 2), and extends from the inner surface 2a side to the outer surface 2b side in the Z-axis direction.

The terminal 22 is an electrode terminal for electrically connecting the first chip 2 and the second chip 3. One terminal 22 is electrically connected to one terminal 32 provided to correspond to one light receiving portion 31 of the second chip 3. That is, an electric signal related to the light detected by each light receiving portion 31 of the second chip 3 is input to each terminal 22.

The insulating layer 23 is provided on the inner surface 2a to surround the terminals 21 and 22 in order to insulate the terminals 21 and 22 from each other. Openings 23a for exposing the terminals 21 and 22 are formed in the insulating layer 23. The insulating layer 23 can be made of, for example, an inorganic film such as silicon dioxide (SiO₂) or an organic film such as polyimide.

The second chip 3 is disposed at a position facing the inner surface 2a of the first chip 2. The second chip 3 is a semiconductor chip having an inner surface 3a (second inner surface) facing the inner surface 2a, an outer surface 3b (second outer surface) which is a surface on an opposite side of the inner surface 3a, and a side surface 3c (second side surface) connecting the inner surface 3a and the outer surface 3b. In the present embodiment, as viewed from the Z-axis direction, the first chip 2 has a size slightly larger than the second chip 3, and the second chip 3 is disposed to overlap a central portion (a region excluding a peripheral portion) of the inner surface 2a of the first chip 2.

The second chip 3 includes a plurality of light receiving portions 31 that receive light incident on the outer surface 3b. The plurality of light receiving portions 31 can be arrayed one-dimensionally or two-dimensionally, for example, as viewed from the Z-axis direction. Each light receiving portion 31 is disposed at a position along the inner surface 3a. For example, each light receiving portion 31 is embedded in the second chip 3 such that a surface on an opposite side to a light incident surface (a surface on the outer surface 3b side) of each light receiving portion 31 is substantially flush with the inner surface 3a. Examples of the light receiving portion 31 include a Si photodiode (SiPD), a Si avalanche photodiode (SiAPD), a multi-pixel photon counter (Si-MPPC), and the like.

A plurality of terminals 32 (second terminals) and an insulating layer 33 are provided on the inner surface 3a of the second chip 3. Each terminal 32 is provided at a position facing each light receiving portion 31, and is electrically connected to each light receiving portion 31. The insulating layer 33 is provided on the inner surface 3a to surround the terminals 32 in order to insulate the terminals 32 from each other. Openings 33a for exposing the terminals 32 are formed in the insulating layer 33. The insulating layer 33 can be made of, for example, an inorganic film such as silicon dioxide (SiO₂) or an organic film such as polyimide.

The terminals 22 and the terminals 32 corresponding to each other are electrically connected via conductive bumps 9 (conductive members) disposed between the terminals 22 and the terminals 32. Note that, under-bump metal (UBM) may be formed by plating or the like between the terminal 22 and the conductive bump 9 and between the terminal 32 and the conductive bump 9. An underfill resin 10 is filled between the insulating layer 23 and the insulating layer 33 to surround each conductive bump 9. As illustrated in FIG. 1, a part of the underfill resin 10 may be provided to protrude from the inner surface 3a of the second chip 3 and cover a part of the side surface 3c of the second chip 3. The underfill resin 10 can be made of, for example, an epoxy resin or the like.

The molding resin 4 seals the first chip 2, the second chip 3, and the wire 8 provided on the insulating layer 5. The molding resin 4 includes the first resin portion 4a covering at least the side surface 2c of the first chip 2 and the second resin portion 4b covering at least the side surface 3c of the second chip 3. In the present embodiment, the first resin portion 4a and the second resin portion 4b are integrally formed without distinction. The molding resin 4 can be made of, for example, an epoxy resin or the like.

The outer surface 3b of the second chip 3 is not covered with the molding resin 4 (second resin portion 4b). An outer surface 4c of the molding resin 4 (a surface of the second resin portion 4b on an opposite side to the first resin portion 4a) is formed to be substantially flush with the outer surface 3b. An antireflection layer 11 is provided on the outer surface 3b and the outer surface 4c. Note that, the antireflection layer 11 may be provided only on the outer surface 3b. That is, the antireflection layer 11 may not be provided on the outer surface 4c. The antireflection layer 11 can be made of, for example, silicon nitride (Si₃N₄), silicon dioxide (SiO₂), aluminum oxide (Al₂O₃), or the like.

### (Method for Producing Optical Semiconductor Package)

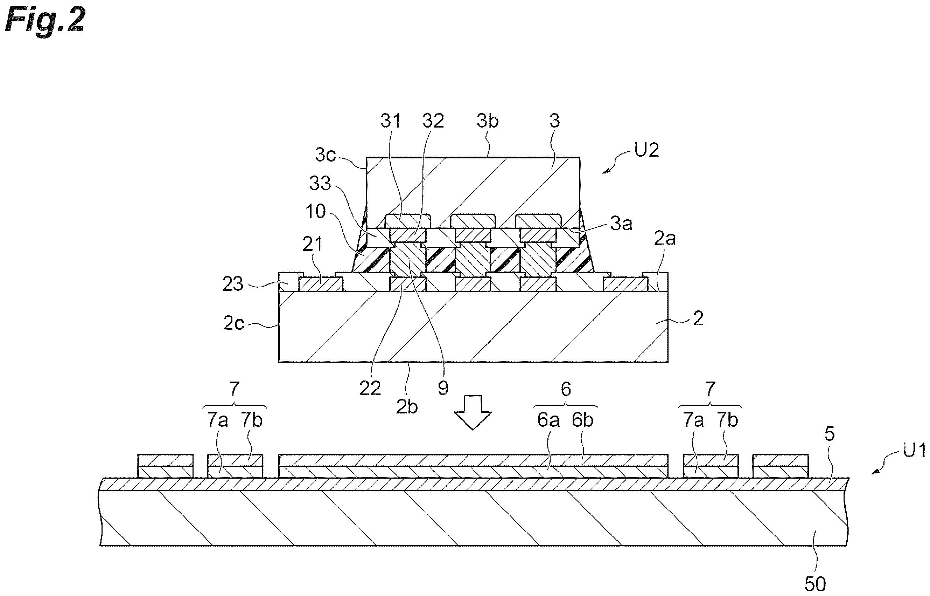

An example of a producing step of the optical semiconductor package 1A will be described with reference to FIGS. 2 to 5. In the present embodiment, the optical semiconductor package 1A is produced by a chip on wafer (CoW) method or a chip on panel (CoP) method.

First, as illustrated in FIG. 2, a substrate unit U1 is formed (first step). The substrate unit U1 is a member including a substrate 50 and the electrode 6 and the electrodes 7 provided on the substrate 50 via the insulating layer 5. The substrate 50 is, for example, a glass substrate, a silicon substrate, a SUS substrate, or the like. On the substrate unit U1, unit regions for a plurality of optical semiconductor packages 1A (that is, regions in which the electrodes 6 and 7 corresponding to the optical semiconductor package 1A are provided) are formed in a lattice shape (two-dimensional shape). FIGS. 2 to 5 illustrate a state of one unit region in each producing step.

In addition, as illustrated in FIG. 2, chip units U2 each including the first chip 2 and the second chip 3 are formed (second step). The chip units U2 are prepared by the number of unit regions provided on the substrate unit U1. As illustrated in FIG. 2, the chip unit U2 is in a state where the terminal 22 of the first chip 2 and the terminal 32 of the second chip 3 are electrically connected by the conductive bump 9. In addition, in the present embodiment, the underfill resin 10 is also formed in the chip unit U2. That is, a structure in which the first chip 2 and the second chip 3 are integrally fixed in a state of being conducted with each other is prepared as the chip unit U2. Note that, the structure of the chip unit U2 is not limited to the above structure. For example, in the chip unit U2, a structure in which the first chip 2 and the second chip 3 are molded and sealed without using the underfill resin 10 may be adopted. Alternatively, a structure in which the terminal 22 of the first chip 2 and the terminal 32 of the second chip 3 are electrically connected by hybrid bonding using copper and an inorganic film may be adopted.

Subsequently, as illustrated in FIG. 2, the chip unit U2 is mounted on the substrate unit U1 by bonding (die bonding) the outer surface 2b of the first chip 2 to the electrode 6 (plating portion 6b) on the substrate unit U1 in each unit region (third step).

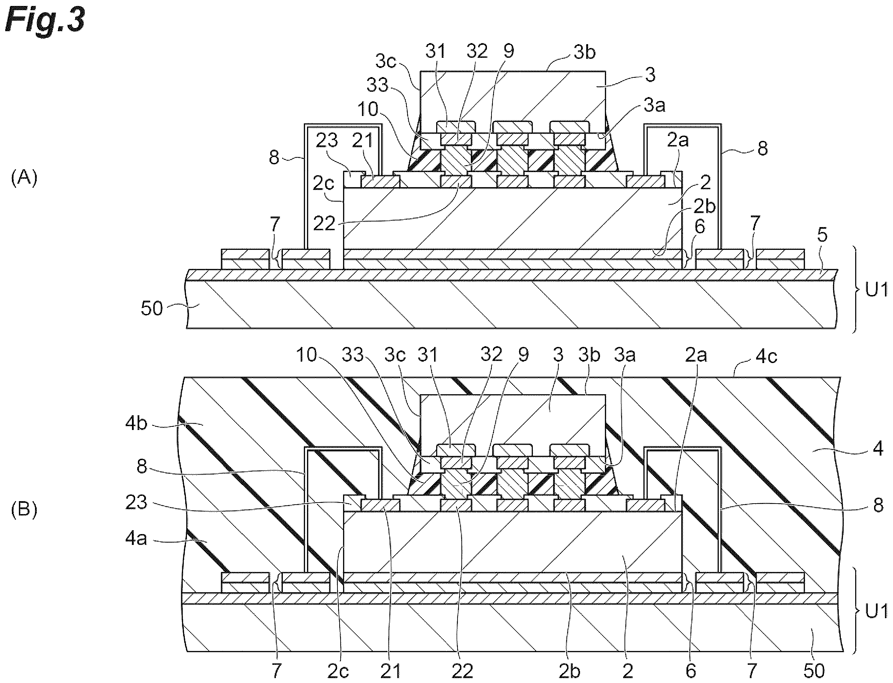

Subsequently, as illustrated in (A) of FIG. 3, the terminal 21 and the electrode 7 (plating portion 7b) are wire-bonded to form the wire 8 (fourth step).

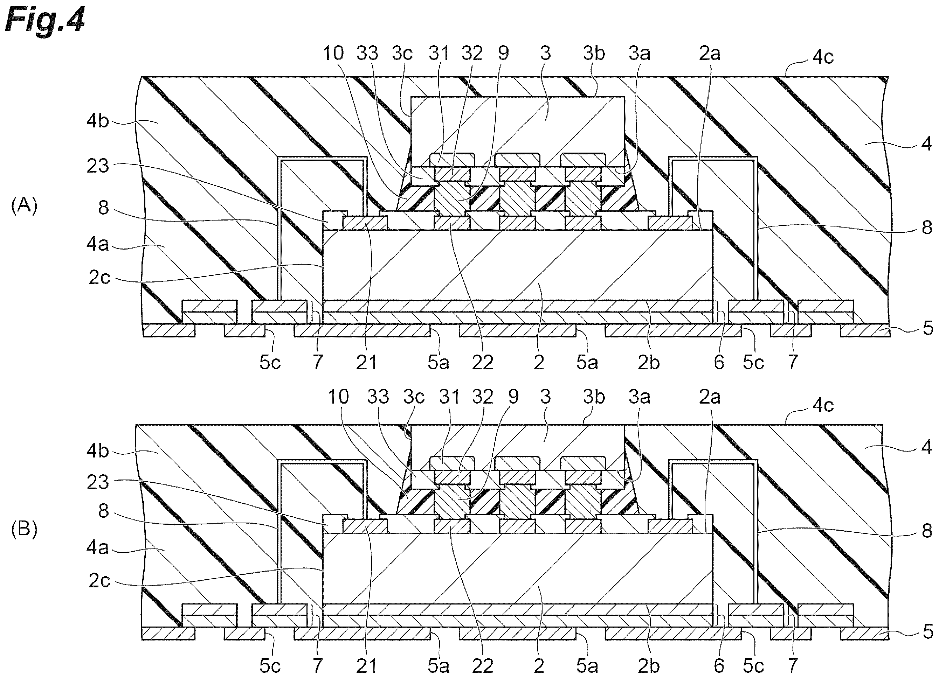

Subsequently, as illustrated in (B) of FIG. 3, the molding resin 4 is formed on the substrate unit U1 to seal the chip unit U2 and the wire 8 disposed in each unit region. Focusing on one unit region, the first resin portion 4a covering the side surface 2c of the first chip 2 and the second resin portion 4b covering the side surface 3c of the second chip 3 are integrally formed (fifth step). For example, as in a first modification to be described later, in a case where the molding resin 4 is made of a light transmissive resin (transparent resin), the molding resin 4 may remain in the state illustrated in (B) of FIG. 3. On the other hand, in the present embodiment, the molding resin 4 is made of a light non-transmissive resin. Thus, the second resin portion 4b is formed (machined) not to cover the outer surface 3b of the second chip 3. That is, in a subsequent step, the outer surface 3b of the second chip 3 is exposed to an outside by removing a part on the outer surface 4c side of the molding resin 4 by polishing, grinding, or the like (see (B) of FIG. 4).

Subsequently, as illustrated in (A) of FIG. 4, the substrate 50 of the substrate unit U1 is removed by polishing, peeling, or the like (sixth step). In addition, openings 5a and 5c for making contact with the electrodes 6 and 7 are formed in portions of the insulating layer 5 corresponding to the electrodes 6 and 7.

Subsequently, as illustrated in (B) of FIG. 4, a part of each unit region on the outer surface 4c side of the molding resin 4 is removed by polishing, grinding, or the like. Note that, in the present specification, "polishing or grinding" includes a case where only one of polishing and grinding is performed and also includes a case where both polishing and grinding are performed. At this time, in each unit region, both the outer surface 4c of the molding resin 4 and the outer surface 3b of the second chip 3 may be polished or ground. That is, after the outer surface 3b of the second chip 3 in each unit region is exposed by polishing or grinding the outer surface 4c of the molding resin 4, processing of collectively polishing or grinding the outer surface 4c of the molding resin 4 and the outer surface 3b of the second chip 3 may be continued. As a result, as illustrated in (B) of FIG. 4, the second chip 3 is thinned, and the outer surface 3b of the second chip 3 is exposed to the outside. Accordingly, the outer surface 3b of the second chip 3 and the outer surface 4c of the molding resin 4 are substantially flush with each other. After the polishing or grinding is performed, for example, treatment processing such as chemical treatment may be executed on the outer surface 3b of the second chip 3. In this case, as a result of removing a part on the outer surface 3b side of the second chip 3 by the treatment processing, a height position of the outer surface 3b is slightly lower than a height position of the outer surface 4c. That is, the outer surface 3b is positioned inside the outer surface 4c (on the first chip 2 side). Note that, in order to set the height position of the outer surface 3b to be sufficiently lower than the height position of the outer surface 4c (in other words, only the second chip 3 is further thinned), chemical treatment such as wet etching may be executed. This case will be described in a second modification to be described later.

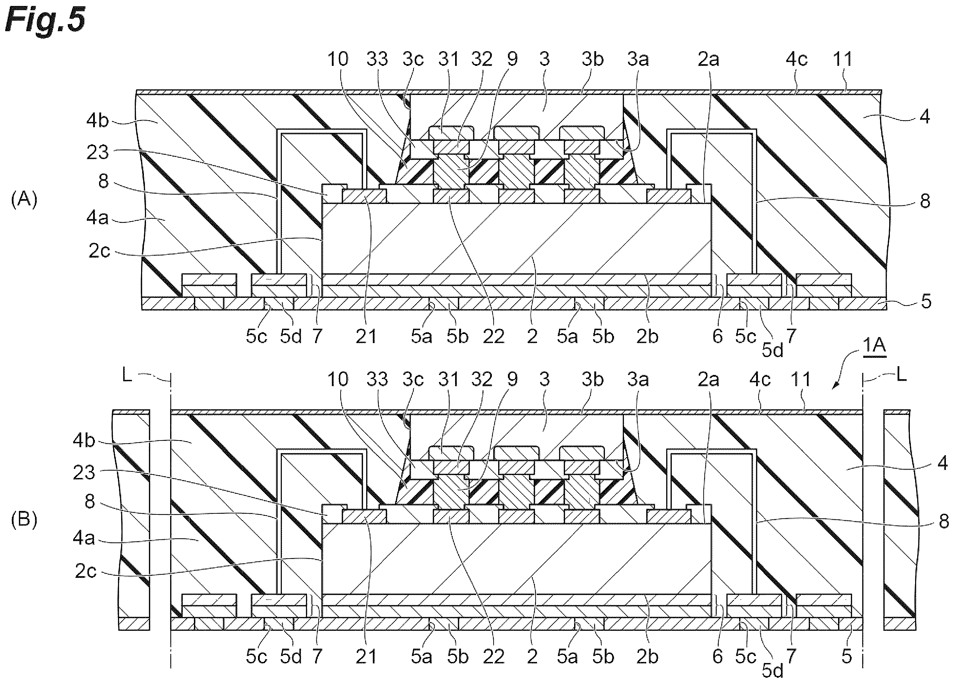

Subsequently, as illustrated in (A) of FIG. 5, the antireflection layer 11 is provided on the outer surface 3b of the second chip 3 in each unit region. Note that, although the antireflection layer 11 may be provided only on the outer surface 3b of the second chip 3, in the present embodiment, since film forming processing is collectively performed on the plurality of unit regions, the antireflection layer 11 is also provided on the outer surface 4c of the molding resin 4. In addition, electroless plating on front surfaces of the metal portions 6a and 7a exposed to the openings 5a and 5c of the insulating layer 5 is performed, and thus, the plating portions 5b and 5d are formed within the openings 5a and 5c.

Subsequently, as illustrated in (B) of FIG. 5, dicing is performed along boundary lines L between the unit regions. Accordingly, a plurality of divided optical semiconductor packages 1A are obtained.

### (Effects)

In the optical semiconductor package 1A, the molding resin 4 (first resin portion 4a and second resin portion 4b) covering the side surfaces 2c and 3c of the first chip 2 and the second chip 3 disposed to be stacked in two stages is integrally provided. That is, the first chip 2 and the second chip 3 are integrally fixed by the molding resin 4. Accordingly, the first chip 2 and the second chip 3 can be appropriately protected. In addition, the electrode terminals (terminals 21, terminals 22, and terminals 32) of the first chip 2 and the second chip 3 are disposed in a region between the first chip 2 and the second chip 3, and thus, the electrode terminals can be appropriately protected from external impact or the like. In addition, in a case where the terminals 32 of the second chip 3 are provided on the outer surface 3b of the second chip 3, the following disadvantage may occur. That is, a part of light incident on the outer surface 3b (that is, light to be detected by the light receiving portion 31) may be reflected by a wiring or the like connected to the terminal 32 and routed to the outer surface 3b side, and this reflected light may be detected, as noise, by the light receiving portion 31. The terminal 32 of the second chip 3 is provided on the inner surface 3a, and thus, the generation of the noise described above can be prevented. As described above, according to the optical semiconductor package 1A, reliability (fastness and stability of a light receiving function of the second chip 3) of the optical semiconductor package 1A can be improved in a structure in which two chips are disposed to be stacked.

In addition, in a case where the terminal 32 electrically connected to the second chip 3 (each light receiving portion 31) is provided on the outer surface 3b, the following disadvantage may further occur. That is, as compared with a case where the terminal 32 is provided on the inner surface 3a, a wiring length of the wiring (for example, a wiring connecting the terminal 32 and the terminal 22) connected to the terminal 32 becomes long. As a result, as compared with a case where the terminal 32 is provided on the inner surface 3a, a disadvantage in electrical characteristic such as deterioration in transmission efficiency of an electric signal between chips and easy mixing of noise may occur. In addition, for example, in a case where the second chip 3 is an area image sensor or the like having a plurality of pixels (light receiving portions 31), it is difficult to route a plurality of wirings to the outer surface 3b not to cover each pixel, and a degree of producing difficulty increases. Further, in a case where an optical component such as a lens is disposed on the outer surface 3b of the second chip 3, since the wiring routed to the outer surface 3b becomes an obstacle, a problem that it is difficult to dispose the optical component may occur. Alternatively, the wiring enters between the optical component and the outer surface 3b, and thus, a gap (void) is generated between the optical component and the outer surface 3b, and a disadvantage in optical characteristic may occur. As described above, according to the optical semiconductor package 1A having the structure in which the terminal 32 of the second chip 3 is provided on the inner surface 3a, the above-described various disadvantages can be avoided.

In addition, the optical semiconductor package 1A includes the insulating layer 5 that covers the outer surface 2b of the first chip 2, and the plating portion 5d that is provided to be exposed to the opposite side to the first chip 2 side of the insulating layer 5 and is electrically connected to the terminal 21. According to the above configuration, the electrical contact with the first chip 2 (terminal 21) can be easily made via the plating portion 5d.

In addition, the outer surface 3b of the second chip 3 is not covered with the molding resin 4 (second resin portion 4b). That is, the second resin portion 4b is formed not to cover the outer surface 3b. According to the above configuration, since incident light on the outer surface 3b is not blocked by the second resin portion 4b provided on the outer surface 3b, the reliability of the light receiving function of the second chip 3 can be enhanced.

In addition, the optical semiconductor package 1A includes the terminal 22 provided on the inner surface 2a of the first chip 2, and the conductive bump 9 electrically connecting the terminal 32 and the terminal 22 of the second chip 3. According to the above configuration, the first chip 2 and the second chip 3 are conducted to with other in the region between the first chip 2 and the second chip 3 appropriately protected by the molding resin 4, and thus, the reliability of the optical semiconductor package 1A can be enhanced.

In addition, the method for producing the optical semiconductor package 1A includes the first step to the sixth step. According to the above producing method, it is possible to easily obtain the optical semiconductor package 1A with improved reliability in the structure in which two semiconductor chips are disposed to be stacked.

### (First Modification)

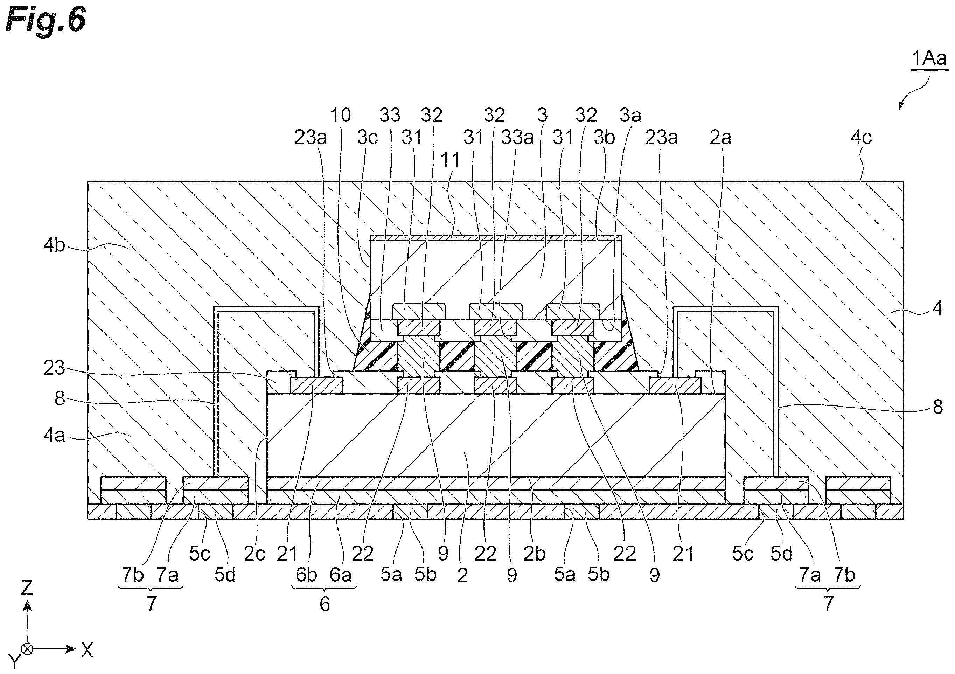

FIG. 6 is a sectional view of an optical semiconductor package 1Aa of a first modification of the first embodiment. Hereinafter, portions of a configuration of the optical semiconductor package 1Aa different from the optical semiconductor package 1A will be described. As illustrated in FIG. 6, the molding resin 4 of the optical semiconductor package 1Aa is made of, for example, a light transmissive resin such as a silicone resin. In addition, the outer surface 3b of the second chip 3 is covered with the molding resin 4 (second resin portion 4b). In addition, the antireflection layer 11 is provided on the outer surface 3b of the second chip 3, and is not provided on the outer surface 4c of the molding resin 4. The optical semiconductor package 1Aa is obtained, for example, by preparing the chip unit U2 in a state where the antireflection layer 11 is provided on the outer surface 3b in advance in the above-described method for producing the optical semiconductor package 1A and omitting the step of polishing or grinding the molding resin 4.

According to the optical semiconductor package 1Aa, since the outer surface 3b of the second chip 3 and the antireflection layer 11 can be appropriately protected by the molding resin 4 (second resin portion 4b), the reliability of the optical semiconductor package 1Aa can be enhanced. In addition, in a resin molding step of forming the molding resin 4, since it is not necessary to remove a part of the second resin portion 4b formed on the outer surface 3b of the second chip 3 by polishing or the like, the producing step can be simplified.

### (Second Modification)

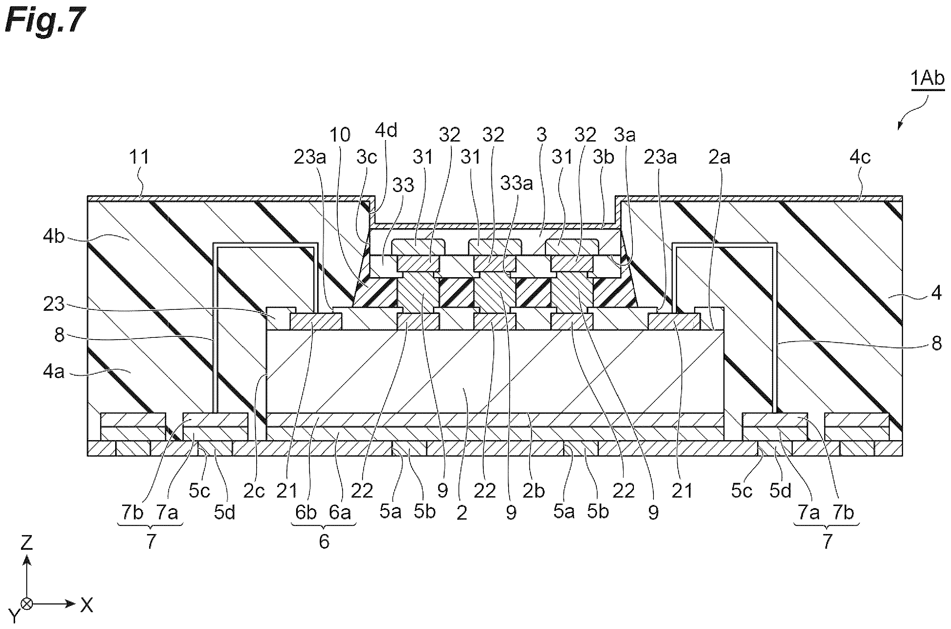

FIG. 7 is a sectional view of an optical semiconductor package 1Ab of a second modification of the first embodiment. Hereinafter, portions of a configuration of the optical semiconductor package 1Ab different from the optical semiconductor package 1A will be described. As illustrated in FIG. 7, in the optical semiconductor package 1Ab, the outer surface 3b of the second chip 3 is positioned closer to the first chip 2 than the outer surface 4c of the second resin portion 4b in the Z-axis direction. That is, the outer surface 3b is recessed inward from the outer surface 4c of the molding resin 4.

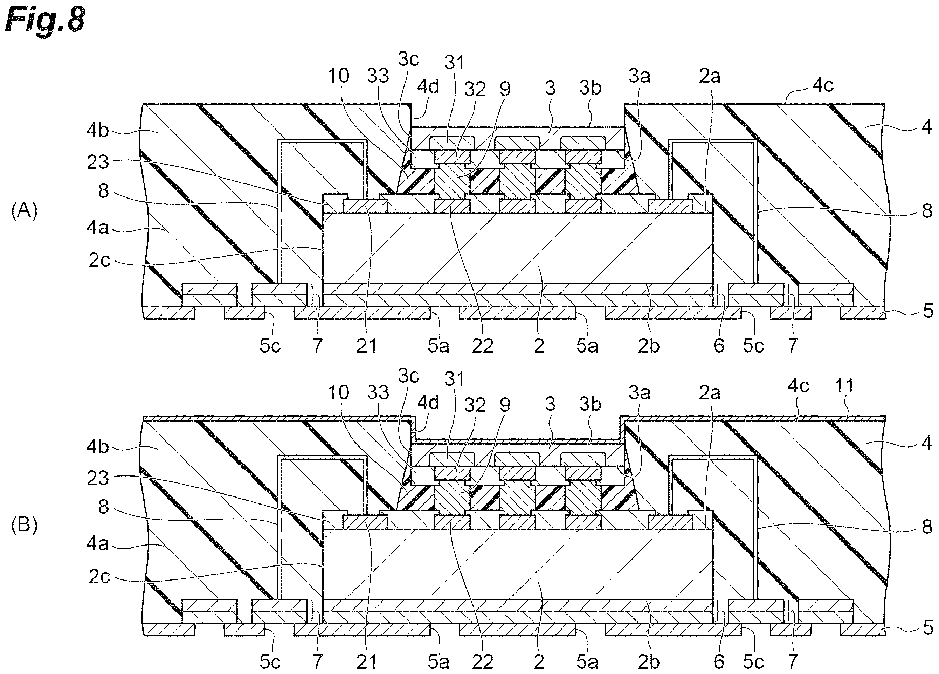

The optical semiconductor package 1Ab can be produced, for example, by the following method. That is, from the state illustrated in (B) of FIG. 4, a part on the outer surface 3b side of the second chip 3 is further removed by chemical treatment such as wet etching. Accordingly, as illustrated in (A) of FIG. 8, the second chip 3 is thinned, and the outer surface 3b of the second chip 3 is positioned inside the outer surface 4c of the molding resin 4.

In order to adjust a thickness of the second chip 3 after wet etching to a constant thickness, an etching stop layer may be provided inside the second chip 3. For example, the second chip 3 may be a silicon on insulator (SOI) substrate having a silicon substrate provided on the inner surface 3a side, a silicon layer provided on the outer surface 3b side, and a BOX layer made of a silicon oxide film (SiO₂) provided between the silicon substrate and the silicon layer. In this case, the BOX layer functions as the etching stop layer. That is, only the silicon layer on the outer surface 3b side can be removed by wet etching. Alternatively, the second chip 3 may include a compound semiconductor such as InGaAs/InP. More specifically, the second chip 3 may include an InP layer provided on the outer surface 3b side and an InGaAs layer provided on the inner surface 3a side of the InP layer. In this case, the InGaAs layer functions as the etching stop layer. That is, only the InP layer on the outer surface 3b side can be removed by wet etching.

Subsequently, the antireflection layer 11 is formed on the plurality of unit regions arrayed in the lattice shape, and thus, as illustrated in (B) of FIG. 8, the antireflection layer 11 is formed along the outer surface 3b of the second chip 3, the outer surface 4c of the molding resin 4, and the side surface 4d of the molding resin 4 connecting the outer surface 3b and the outer surface 4c.

As described above, a method for producing the optical semiconductor package 1Ab includes a step of removing a part on the outer surface 3b side of the second chip 3 such that the outer surface 3b of the second chip 3 is positioned closer to the first chip 2 than the outer surface 4c of the second resin portion 4b. That is, in the optical semiconductor package 1Ab, the second chip 3 is thinned such that the outer surface 3b is positioned inside the outer surface 4c of the molding resin 4. Accordingly, since the amount of attenuation of the light passing through the inside of the second chip 3 can be reduced, the light receiving function of the second chip 3 can be effectively enhanced. That is, since the amount of light detected by the light receiving portion 31 in the light incident on the outer surface 3b can be increased, light receiving sensitivity can be enhanced. In addition, a boundary portion (corner portion) between the outer surface 3b and the side surface 3c of the second chip 3 can be appropriately protected by the side surface 4d of the molding resin 4 and the antireflection layer 11. In addition, since the outer surface 3b is positioned closer to the first chip 2 than the outer surface 4c, the following effects are also obtained. That is, in a case where a front surface of the optical semiconductor package 1Ab (in this example, a front surface on which the antireflection layer 11 is provided) comes into contact with another member, a possibility that the outer surface 3b of the second chip 3 (the portion of the antireflection layer 11 covering the outer surface 3b) comes into direct contact with the other member can be reduced. As a result, damage to the second chip 3 caused by contact between the optical semiconductor package 1Ab and another member can be suppressed.

Note that, even in a case where treatment processing is executed on the outer surface 3b of the second chip 3 in the first embodiment, a part on the outer surface 3b side of the second chip 3 is removed by the treatment processing, and as a result, a structure in which the outer surface 3b is positioned closer to the first chip 2 than the outer surface 4c can be formed. In this case, effects similar to the second modification described above are also obtained.

### (Third Modification)

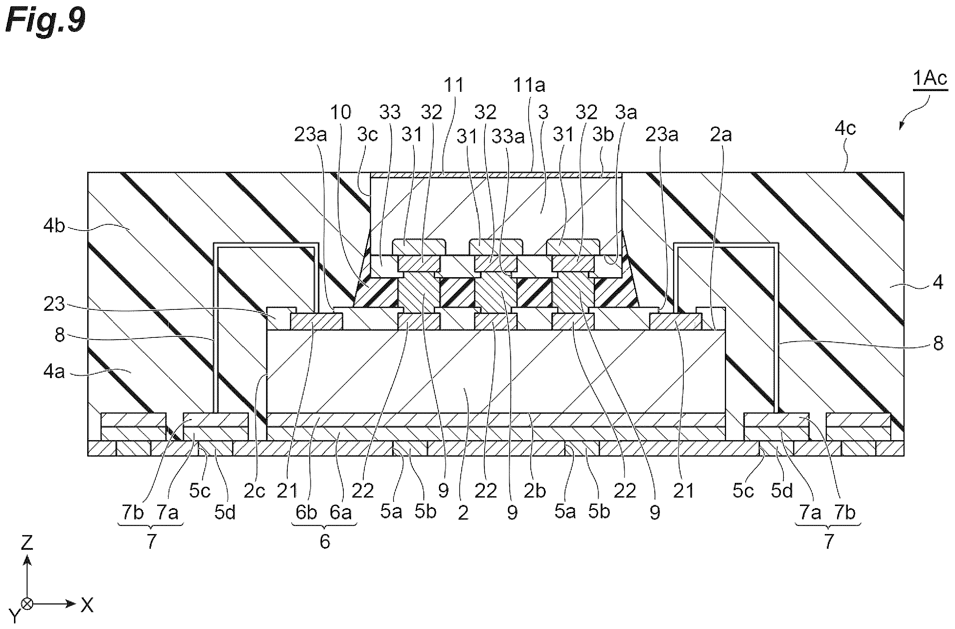

FIG. 9 is a sectional view of an optical semiconductor package 1Ac of a third modification of the first embodiment. Hereinafter, portions of a configuration of the optical semiconductor package 1Ac different from the optical semiconductor package 1A will be described. As illustrated in FIG. 9, in the optical semiconductor package 1Ac, the antireflection layer 11 is provided only on the outer surface 3b of the second chip 3. In addition, an outer surface 11a of the antireflection layer 11 and the outer surface 4c of the molding resin 4 are substantially flush with each other.

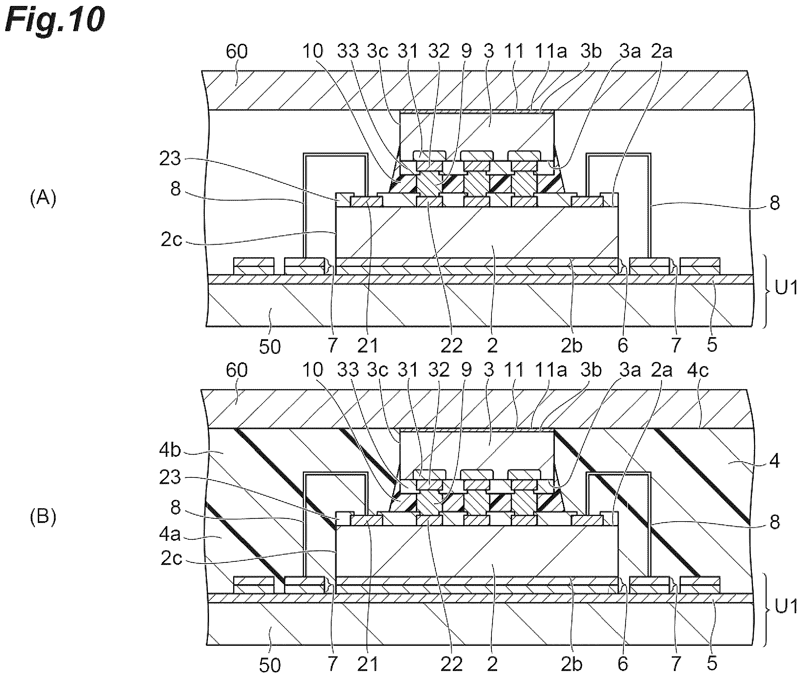

The optical semiconductor package 1Ac can be produced by, for example, the following method. That is, similarly to the first modification (optical semiconductor package 1Aa) described above, the chip unit U2 in a state where the antireflection layer 11 is provided on the outer surface 3b in advance is prepared. Then, as illustrated in FIG. 10, the molding resin 4 is formed by transfer molding. Specifically, as illustrated in (A) of FIG. 10, a release film 60 is disposed along the outer surface 3b of each second chip 3 formed in each unit region. The release film 60 is temporarily adhered to the outer surface 11a of each antireflection layer 11 on the outer surface 3b of each second chip 3. Thereafter, as illustrated in (B) of FIG. 10, a region (space) between the substrate unit U1 and the release film 60 is filled with the molten the molding resin 4. Subsequently, after the molding resin 4 is cured, the release film 60 is peeled off from each antireflection layer 11. Thereafter, as in the first embodiment, processing such as the removal of the substrate 50, the formation of the openings 5a and 5c and the plating portions 5b and 5d of the insulating layer 5, and the division by dicing is performed, and thus, the optical semiconductor package 1Ac is obtained.

According to the optical semiconductor package 1Ac, the antireflection layer 11 can be formed only on the outer surface 3b of the second chip 3, and unnecessary portions provided on the outer surface 4c of the molding resin 4 can be reduced. In addition, the molding resin 4 is formed by transfer molding as illustrated in (A) and (B) of FIG. 10, processing of removing a part on the outer surface 4c side of the molding resin 4 required in the first embodiment (see (B) of FIG. 4) becomes unnecessary. Accordingly, the producing step can be simplified.

### (Fourth Modification)

In the optical semiconductor package 1A, the light receiving portion 31 may be replaced with a light emitting portion that generates light emitted from the outer surface 3b to the outside. The light emitting portion is, for example, an LED array or the like. That is, the second chip 3 may be a light emitting element having a light emitting portion instead of a light receiving element having the light receiving portion 31. In this case, the reliability of the optical semiconductor package can also be improved by the configuration of the first embodiment (the configuration in which the terminal 32 of the second chip 3 is provided on the inner surface 3a instead of the outer surface 3b). Specifically, in a case where the terminal 32 of the second chip 3 is provided on the outer surface 3b, and in a case where the second chip 3 is the light emitting element having the light emitting portion, a part of emitted light emitted from the outer surface 3b is reflected by a wiring or the like connected to the terminal 32 and routed to the outer surface 3b side, and this reflected light is output, as noise, to the outside. The terminal 32 of the second chip 3 is provided on the inner surface 3a, and thus, the generation of the noise described above can be prevented. As a result, the reliability of the optical semiconductor package (stability of the light emitting function of the second chip 3) can be improved. In addition, in the fourth modification, in a case where the structure of the second modification described above is adopted, the light emitting function of the second chip 3 can be effectively enhanced. That is, since the amount of attenuation of light from the light emitting portion toward the outer surface 3b through an inside of the second chip 3 can be reduced, the amount of light emitted to the outside can be enhanced.

### (Other Modifications)

The second chip 3 may not necessarily have the plurality of light receiving portions 31 (or light emitting portions). That is, the second chip 3 may include only one light receiving portion 31 (or light emitting portion). In addition, the members constituting the optical semiconductor package described above may be appropriately changed or omitted. For example, the underfill resin 10 may be omitted. In addition, the terminal 22 and the terminal 32 may be electrically connected by hybrid bonding using copper and an inorganic film instead of the conductive bump 9. In addition, in the first embodiment, although the backside incidence type (backside emission type) structure in which the light receiving portion 31 (or light emitting portion) is disposed on a back surface (inner surface 3a) side of the second chip 3 has been illustrated, a front surface incidence type (front surface emission type) structure in which the light receiving portion 31 (or light emitting portion) is disposed on a front surface (outer surface 3b) side of the second chip 3 may be adopted. However, in this case, in order to make electrical contact with the light receiving portion 31 (or light emitting portion) from the inner surface 3a side of the second chip 3, it is necessary to provide a through-electrode or the like from the inner surface 3a to the light receiving portion 31 (or light emitting portion) within the second chip 3. Therefore, from the viewpoint of simplifying an electrical connection configuration of the second chip 3, the backside incidence type (backside emission type) structure is more preferable. In addition, optical components such as glass, a band pass filter, or a lens may be attached onto the outer surface 3b of the second chip 3 (in the present embodiment, on the antireflection layer 11 on the outer surface 3b). In addition, in the optical semiconductor package, one or a plurality of other chips may be disposed between the first chip 2 and the second chip 3. Such another chip may be electrically connected to, for example, the first chip 2 or the second chip 3 (or both the first chip 2 and the second chip 3), or may not be electrically connected to either the first chip 2 or the second chip 3. In a latter case, in order to make electrical contact with the other chip, a wiring or the like for electrically connecting a terminal of the other chip and a contact portion (for example, a member similar to the plating portion 5d) exposed on a back surface (that is, the outer surface of the insulating layer 5) of the optical semiconductor package may be provided in the optical semiconductor package.

### [Second Embodiment]

### (Structure of Optical Semiconductor Package)

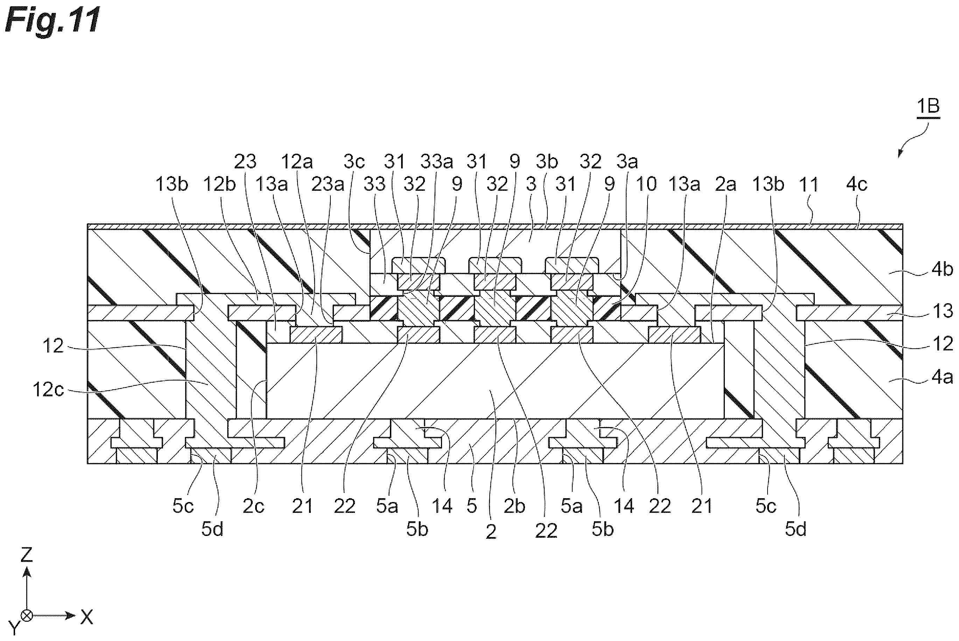

As illustrated in FIG. 11, an optical semiconductor package 1B of a second embodiment is different from the optical semiconductor package 1A mainly in that the electrodes 6 and 7 are not provided, a metal wiring 12 (first wiring) formed by a semiconductor process is provided instead of the wire 8 formed by wire bonding, and an insulating layer 13 is provided between the first resin portion 4a and the second resin portion 4b. Hereinafter, portions of a configuration of the optical semiconductor package 1B different from the optical semiconductor package 1A will be described, and portions of the configuration of the optical semiconductor package 1B similar to the optical semiconductor package 1A will not be described.

In the optical semiconductor package 1B, on the insulating layer 5 on which the first chip 2 is placed, the first resin portion 4a is formed to cover the side surface of the insulating layer 23 provided on the inner surface 2a of the first chip 2 and the side surface 2c of the first chip 2. The insulating layer 13 is provided on the first resin portion 4a and the insulating layer 23. The insulating layer 13 is made of, for example, polyimide or the like. The second resin portion 4b is provided on the insulating layer 13 to cover the side surface 3c of the second chip 3. That is, the first resin portion 4a and the second resin portion 4b are continuously provided via the insulating layer 13 (another member). More specifically, on sides of the first chip 2 and the second chip 3, the first resin portion 4a, the insulating layer 13, and the second resin portion 4b are integrally formed not to form a void between these members. However, the configurations of the first resin portion 4a, the insulating layer 13, and the second resin portion 4b are not limited to the configurations described above. For example, an end portion of the insulating layer 13 in the X-axis direction may be positioned inside an end portion of the optical semiconductor package 1B in the X-axis direction. That is, the first resin portion 4a or the second resin portion 4b may be formed to cover the end portion of the insulating layer 13 in the X-axis direction. In this case, the first resin portion 4a and the second resin portion 4b are integrally (continuously) provided in a region outside the end portion of the insulating layer 13 in the X-axis direction.

The metal wiring 12 is a wiring for electrically connecting the terminal 21 and the external device (for example, a printed wiring board on which the optical semiconductor package 1B is mounted). The metal wiring 12 is, for example, a copper (Cu) wiring. Openings 13a communicating with the opening 23a provided in the insulating layer 23 are formed in the insulating layer 13 to expose the terminals 21. In addition, in the insulating layer 13, an opening 13b penetrating from the first resin portion 4a side to the second resin portion 4b side is formed outside the side surface 2c of the first chip 2. In addition, as in the first embodiment, in the insulating layer 5, the openings 5c penetrating from the inside of the insulating layer 5 (on the first resin portion 4a side) to the outside of the insulating layer 5 are formed at the positions not overlapping with the first chip 2 (a position outside the side surface 2c of the first chip 2).

The metal wiring 12 is electrically connected to the terminal 21, passes through the inside of the first resin portion 4a, and extends from the inner surface 2a side to the outer surface 2b side in the Z-axis direction. In the present embodiment, the end portion on the terminal 21 side of the metal wiring 12 is connected to the terminal 21 via the opening 13a and the opening 23a. In addition, the metal wiring 12 includes a portion 12a extending from the terminal 21 to an upper surface (a surface on the second resin portion 4b side) of the insulating layer 13, a portion 12b extending from an end portion of the portion 12a to the opening 13b along the upper surface of the insulating layer 13, and a portion 12c extending from an end portion of the portion 12b to the opening 5c through the inside of the first resin portion 4a via the opening 13b. The plating portion 5d similar to the plating portion of the first embodiment is provided on the front surface of the end portion of the portion 12c disposed within the opening 5c. In addition, as in the first embodiment, the opening 5a is formed in the portion of the insulating layer 5 overlapping the first chip 2. A metal wiring 14 is provided within the opening 5a. The plating portion 5b similar to the plating portion of the first embodiment is provided at an end portion of the metal wiring 14.

### (Method for Producing Optical Semiconductor Package)

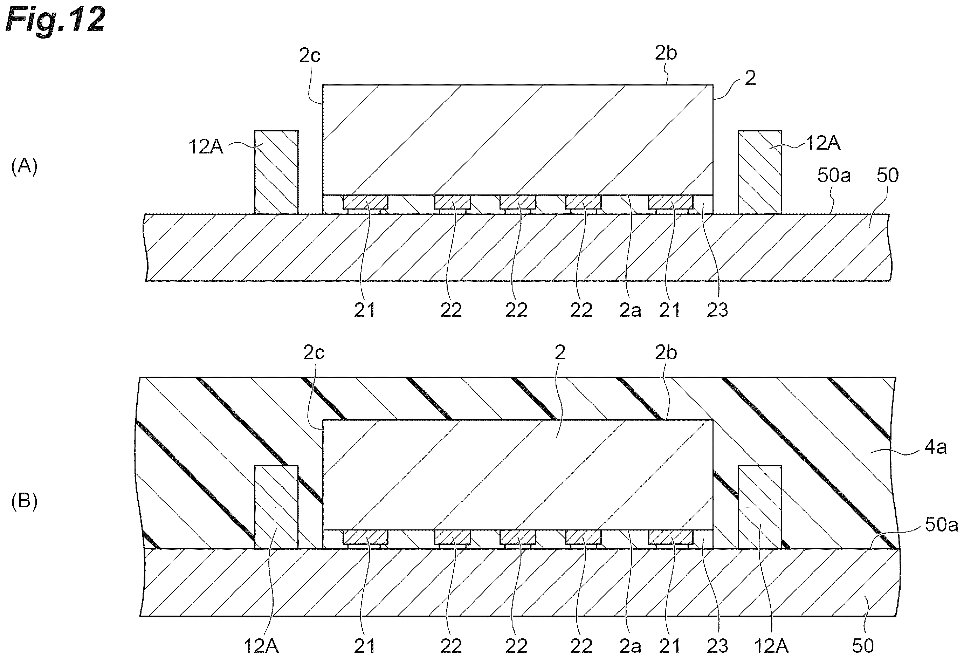

An example of a producing step of the optical semiconductor package 1B will be described with reference to FIGS. 12 to 17. In the present embodiment, the optical semiconductor package 1B is produced by a CoW method or a CoP method. FIGS. 12 to 17 illustrate a state of one unit region in each producing step. Hereinafter, description will be made focusing on only one unit region.

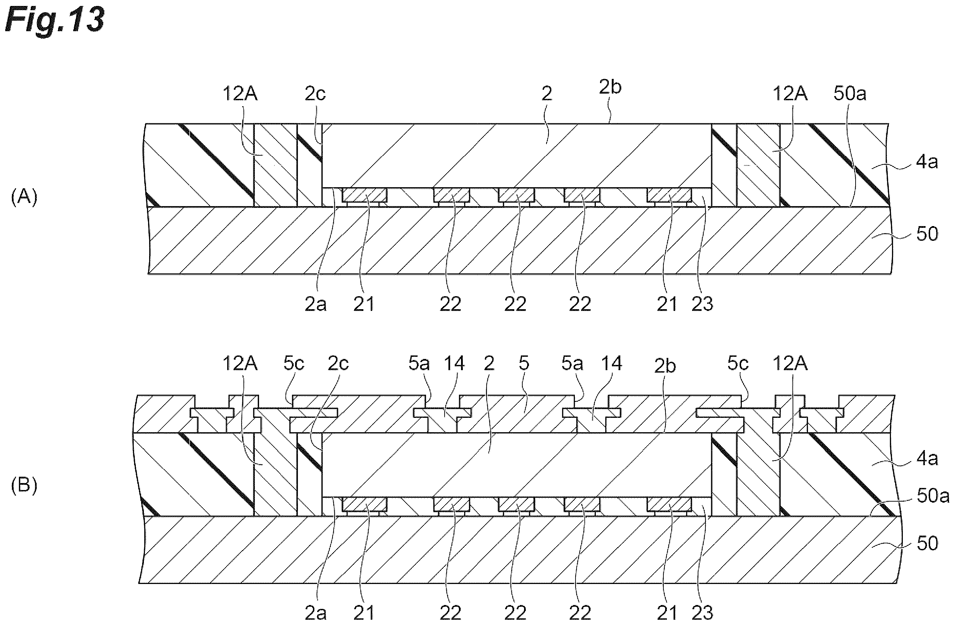

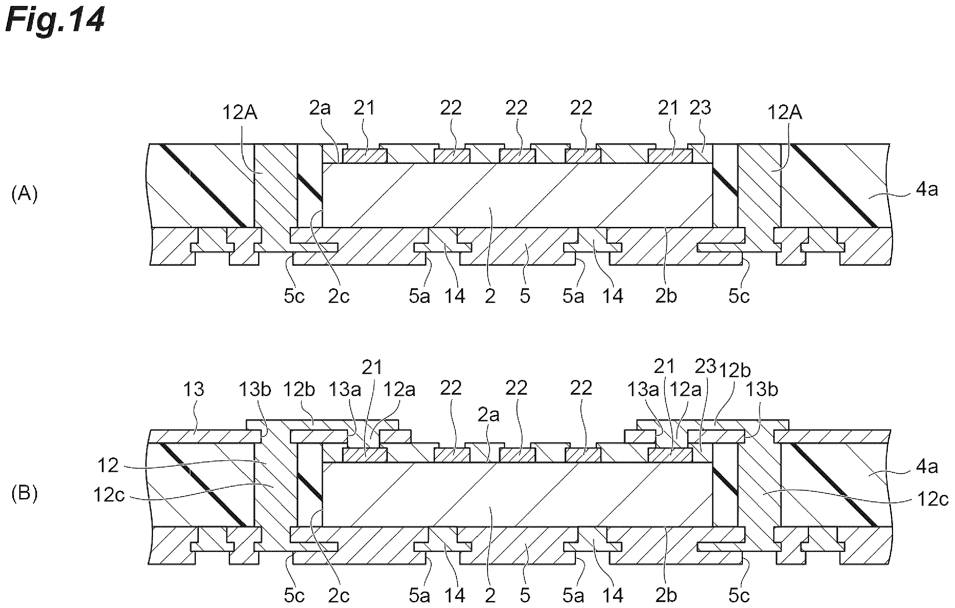

First, the first chip 2 and the first resin portion 4a in which a part (portion 12c) of the metal wiring 12 is embedded are formed (first step). An example of the first step will be described with reference to FIGS. 12, 13 and (A) of FIG. 14. First, as illustrated in (A) of FIG. 12, for example, the substrate 50 such as a glass substrate, a silicon substrate, or an SUS substrate is prepared. A columnar metal member 12A including a portion to be a part (portion 12c) of the metal wiring 12 is temporarily bonded to a front surface 50a of the substrate 50 via a temporary bonding material. In addition, similarly to the metal member 12A, the first chip 2 is temporarily bonded to the front surface 50a of the substrate 50 via the temporary bonding material. The first chip 2 is temporarily bonded to the front surface 50a such that the inner surface 2a and the front surface 50a face each other. That is, the insulating layer 23 provided on the inner surface 2a of the first chip 2 is temporarily bonded to the front surface 50a.

Subsequently, as illustrated in (B) of FIG. 12, the first resin portion 4a is formed on the front surface 50a of the substrate 50 to seal the first chip 2 and the metal member 12A disposed on the substrate 50. At this point in time, the first resin portion 4a is formed to cover the outer surface 2b of the first chip 2.

Subsequently, as illustrated in (A) of FIG. 13, the first resin portion 4a, the first chip 2, and the metal member 12A are collectively polished or ground. Accordingly, after polishing or grinding, the outer surface 2b of the first chip 2, an upper surface of the metal member 12A, and a front surface of the first resin portion 4a are substantially flush with each other, and the outer surface 2b of the first chip 2 and the upper surface of the metal member 12A are exposed to the outside.

Subsequently, as illustrated in (B) of FIG. 13, the insulating layer 5 is formed on the outer surface 2b of the first chip 2, the upper surface of the metal member 12A, and the front surface of the first resin portion 4a, and the metal wiring 14 and a part of the metal wiring 12 (a portion of the portion 12c disposed within the opening 5c of the insulating layer 5) are formed. For example, from the state illustrated in (A) of FIG. 13, the structure illustrated in (B) of FIG. 13 is obtained by patterning the insulating layer 5 and patterning the metal wirings 12 and 14 by using a semiconductor process (seed layer formation, photolithography, electrolytic plating, or the like).

Subsequently, as illustrated in (A) of FIG. 14, the substrate 50 provided on the inner surface 2a side of the first chip 2 is peeled off. As described above, the first step described above is completed.

Subsequently, as illustrated in (B) of FIG. 14, the insulating layer 13 provided with the metal wiring 12 is formed around the terminal 21 on the inner surface 2a of the first chip 2 and on the first resin portion 4a (second step). That is, the insulating layer 13 is formed on the inner surface 2a (insulating layer 23) of the first chip 2 and the front surface of the first resin portion 4a, and a part (mainly, portion 12a and portion 12b) of the metal wiring 12 is formed. For example, from the state illustrated in (A) of FIG. 14, the structure illustrated in (B) of FIG. 14 is obtained by patterning the insulating layer 13 and patterning the metal wiring 12 by using a semiconductor process (seed layer formation, photolithography, electrolytic plating, or the like).

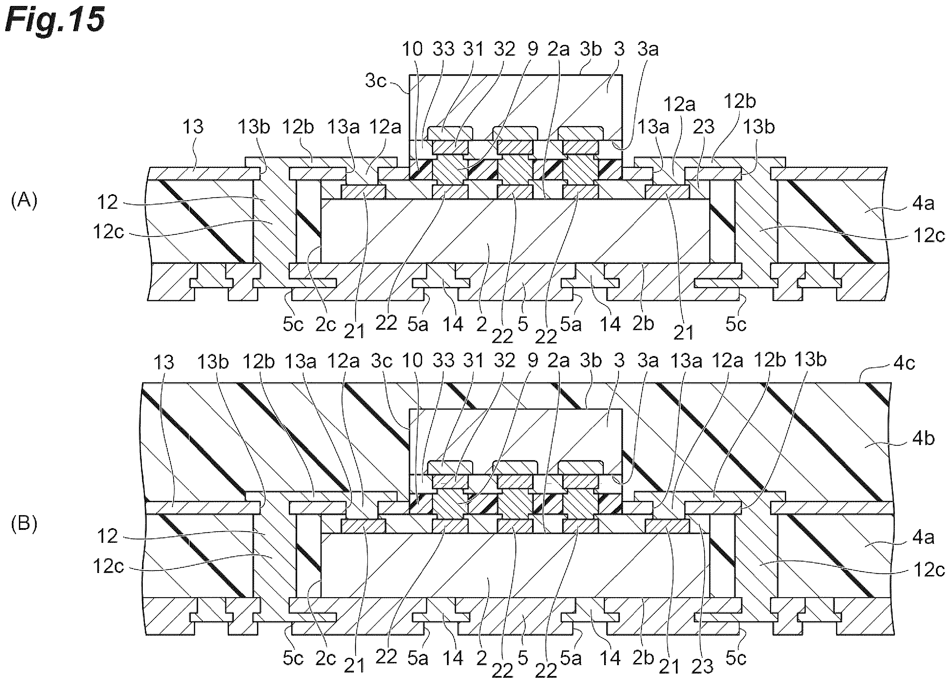

Subsequently, as illustrated in (A) of FIG. 15, the second chip 3 is disposed on the first chip 2 such that the terminal 32 of the second chip 3 and the terminal 22 of the first chip 2 are electrically connected by the conductive bump 9 (third step). In addition, the underfill resin 10 is filled between the first chip 2 (insulating layer 23) and the second chip 3 (insulating layer 33) to surround the conductive bump 9.

Subsequently, as illustrated in (B) of FIG. 15, the second resin portion 4b is formed after the third step (fourth step). In the present embodiment, the second resin portion 4b is formed to be continuous with the first resin portion 4a via the insulating layer 13. At this stage, the second resin portion 4b is formed to cover the outer surface 3b of the second chip 3.

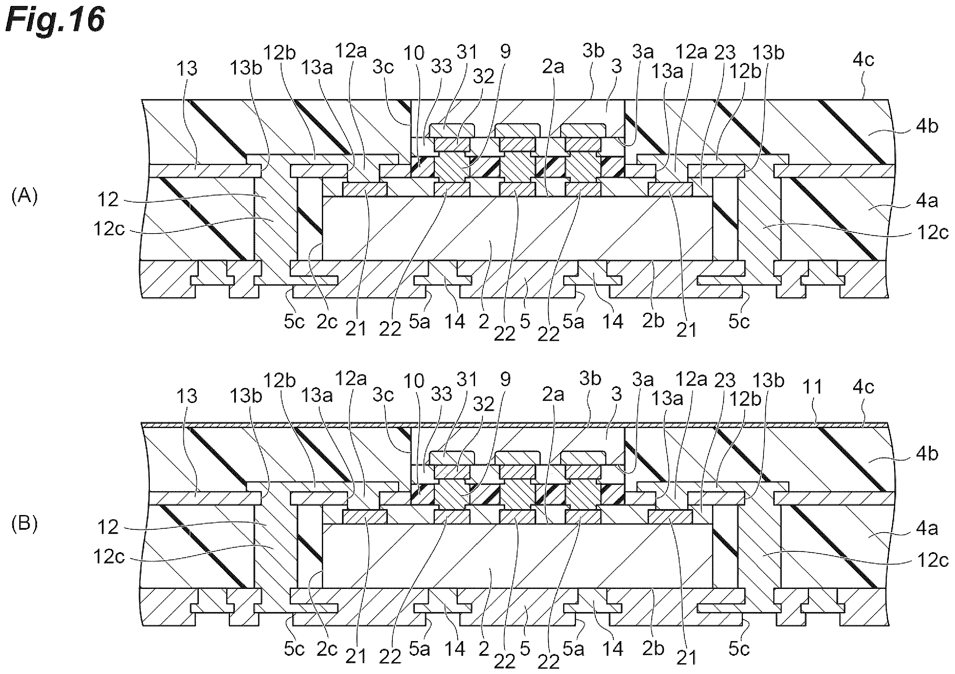

Subsequently, as illustrated in (A) of FIG. 16, a part on the outer surface 4c side of the second resin portion 4b is removed by polishing, grinding, or the like. At this time, the outer surface 4c of the second resin portion 4b and the outer surface 3b of the second chip 3 may be polished or ground together. As a result, as illustrated in (A) of FIG. 16, the second chip 3 is thinned, and the outer surface 3b of the second chip 3 is exposed to the outside. Accordingly, the outer surface 3b of the second chip 3 and the outer surface 4c of the second resin portion 4b are substantially flush with each other.

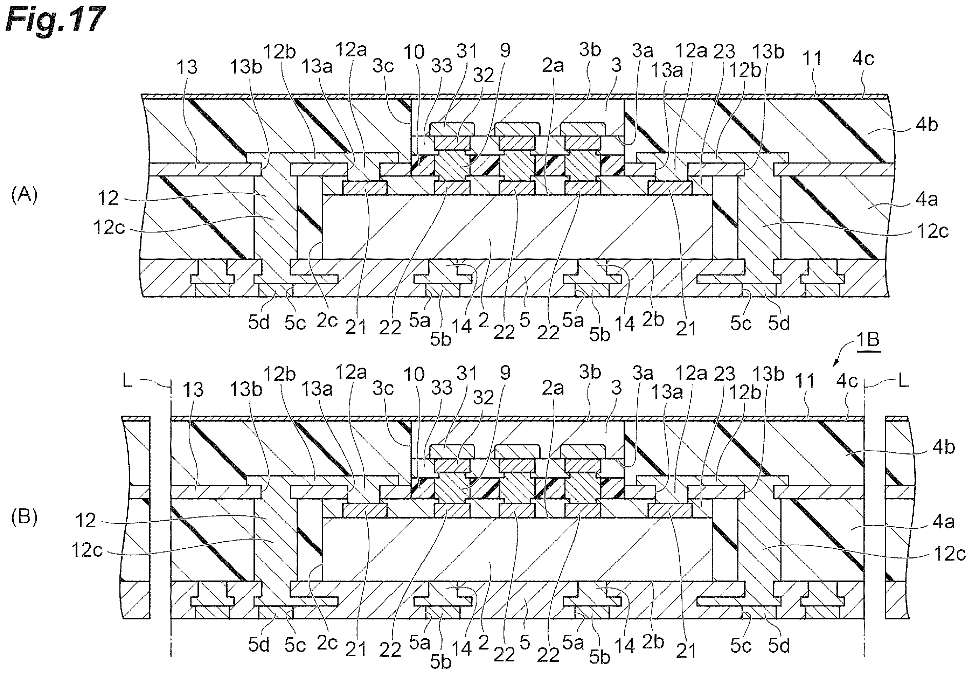

Subsequently, as illustrated in (B) of FIG. 16, the antireflection layer 11 is provided on the outer surface 3b of the second chip 3 and the outer surface 4c of the second resin portion 4b. In addition, as illustrated in (A) of FIG. 17, electroless plating is performed on the front surfaces of the metal wirings 14 and 12 exposed to the openings 5a and 5c of the insulating layer 5, and thus, the plating portions 5b and 5d are formed within the openings 5a and 5c. Subsequently, as illustrated in (B) of FIG. 17, dicing is performed along boundary lines L between the unit regions. Accordingly, a plurality of divided optical semiconductor packages 1B are obtained.

### (Effects)

In the optical semiconductor package 1B, the first resin portion 4a and the second resin portion 4b covering the side surfaces 2c and 3c of the first chip 2 and the second chip 3 disposed to be stacked in two stages are continuously provided via another member (insulating layer 13). That is, the first chip 2 and the second chip 3 are integrally fixed by the first resin portion 4a, the second resin portion 4b, and another member (insulating layer 13). Accordingly, the first chip 2 and the second chip 3 can be appropriately protected. In addition, as in the first embodiment, the electrode terminals (terminal 21 and terminal 32) of the first chip 2 and the second chip 3 are disposed in the region between the first chip 2 and the second chip 3. Accordingly, effects similar to the effects of the first embodiment can be obtained. That is, the reliability (fastness and stability of the light receiving function of the second chip 3) of the package can be improved.

In addition, a method for producing the optical semiconductor package 1B includes the first step to the fourth step. According to the above producing method, it is possible to easily obtain the optical semiconductor package 1B with improved reliability in the structure in which two semiconductor chips are disposed to be stacked.

Note that, in the second embodiment, a structure similar to the structures of the first modification to the fourth modification of the first embodiment described above, and other modifications can also be applied.

### [Third Embodiment]

### (Structure of Optical Semiconductor Package)

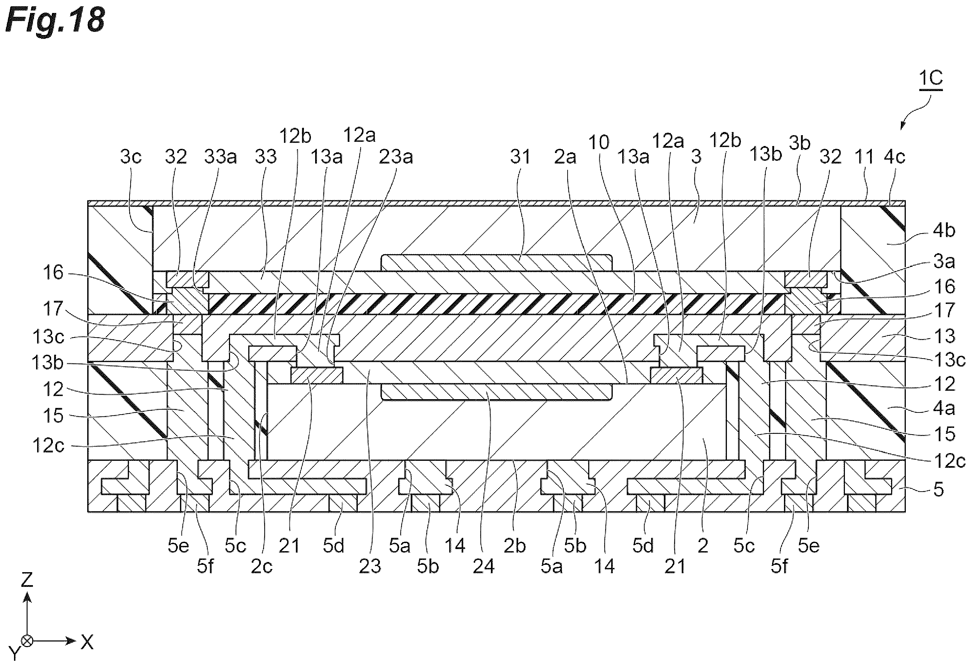

As illustrated in FIG. 18, an optical semiconductor package 1C of a third embodiment is different from the optical semiconductor package 1B mainly in that the first chip 2 and the second chip 3 are not directly electrically connected and the first chip 2 is a light receiving element including a light receiving portion 24. Hereinafter, portions of a configuration of the optical semiconductor package 1C different from the optical semiconductor package 1B will be described, and portions of the configuration of the optical semiconductor package 1C similar to the optical semiconductor package 1B will not be described.

In the optical semiconductor package 1C, a circuit that processes a signal related to light detected by light receiving portion 31 of the second chip 3 is implemented not on the first chip 2 but on the external device (for example, a printed wiring board on which the optical semiconductor package 1C is mounted). Thus, the terminal 32 of the second chip 3 is connected not to the first chip 2 but to the external device. That is, the optical semiconductor package 1C includes a metal wiring 15 (second wiring) for electrically connecting the terminal 32 and the external device.

The metal wiring 15 is electrically connected to the terminal 32, passes through the inside of the first resin portion 4a, and extends from the inner surface 2a side to the outer surface 2b side in the Z-axis direction. In the present embodiment, an opening 5e penetrating from the inside of the insulating layer 5 (first resin portion 4a side) to the outside of the insulating layer 5 is formed at a position of the insulating layer 5 not overlapping the first chip 2 (a position outside the side surface 2c of the first chip 2). In addition, in the insulating layer 13, an opening 13c penetrating from the first resin portion 4a side to the second resin portion 4b side is formed outside the side surface 2c of the first chip 2, separately from the opening 13b. The metal wiring 15 is electrically connected to the terminal 32 via the opening 13c, passes through the inside of the first resin portion 4a, and extends from an inside of the opening 13c to an inside of the opening 5e. In the present embodiment, the metal wiring 15 is provided outside the metal wiring 12 in the X-axis direction. However, the disposition of the metal wiring 12 and the metal wiring 15 is not limited to the above disposition. For example, the metal wiring 12 and the metal wiring 15 are disposed to be shifted from each other in the Y-axis direction, and thus the metal wiring 12 may be disposed outside the metal wiring 15 in the X-axis direction.

A plating portion 17 is provided on a front surface of an end portion of the metal wiring 15 within the opening 13c. The plating portion 17 is, for example, two-layer plating of nickel and gold (Ni/Au plating). The plating portion 17 is electrically connected to the terminal 32 via a conductive bump 16. The underfill resin 10 is filled between the second chip 3 (insulating layer 33) and the insulating layer 13 to surround the conductive bump 16. Note that, instead of the underfill resin 10, a part of the second resin portion 4b may enter between the insulating layer 33 and the insulating layer 13.

A plating portion 5f is provided on the front surface of the end portion of the metal wiring 15 within the opening 5e (that is, a front surface exposed to an outer surface of the insulating layer 5). A material of the plating portion 5f is similar to materials of the plating portions 5b and 5d. The plating portion 5f is a portion bonded to a printed circuit board or the like by, for example, solder or the like.

In the optical semiconductor package 1C, the signal related to the light detected by the light receiving portion 31 of the second chip 3 is transmitted to the external device such as a printed wiring board via the terminal 32, the conductive bump 16, the plating portion 17, the metal wiring 15, and the plating portion 5f. In addition, a signal related to light detected by the light receiving portion 24 of the first chip 2 is transmitted to the external device such as a printed wiring board via the terminal 21, the metal wiring 12, and the plating portion 5d.

### (Method for Producing Optical Semiconductor Package)

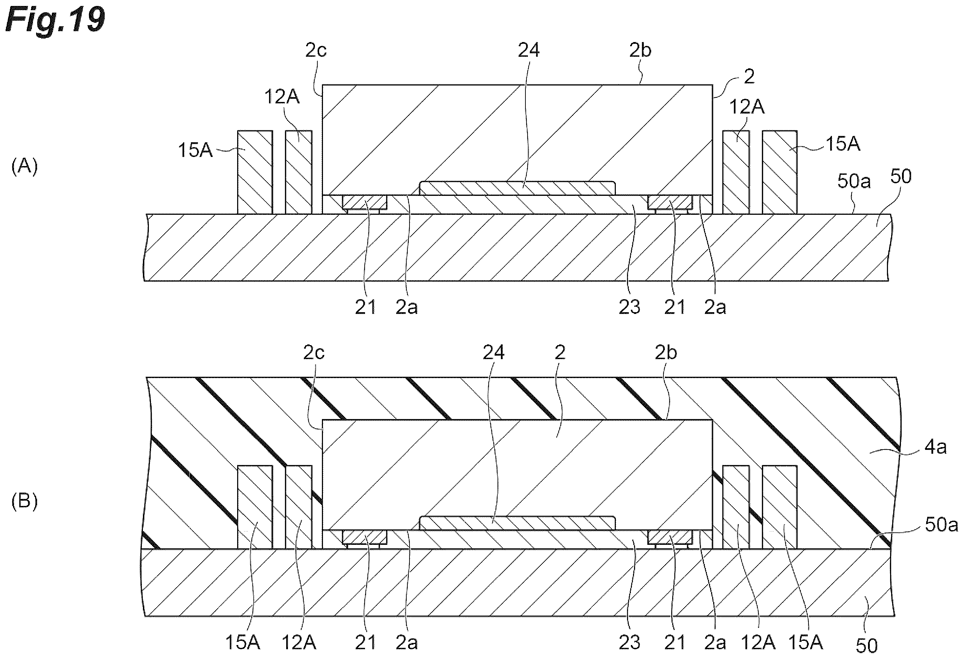

An example of a producing step of the optical semiconductor package 1C will be described with reference to FIGS. 19 to 24. In the present embodiment, the optical semiconductor package 1C is produced by a CoW method or a CoP method. FIGS. 19 to 24 illustrate a state of one unit region in each producing step. Hereinafter, description will be made focusing on only one unit region.

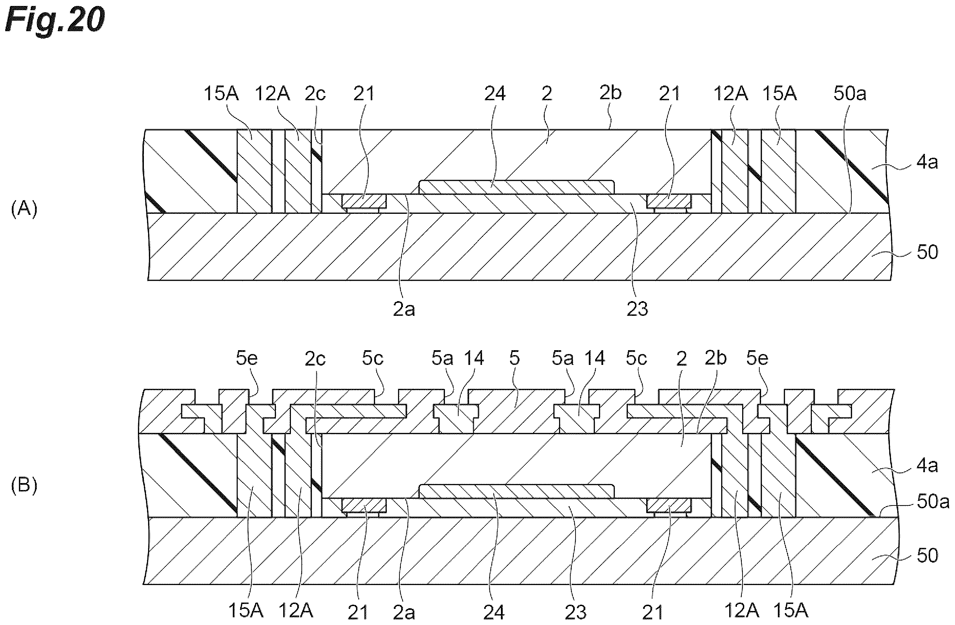

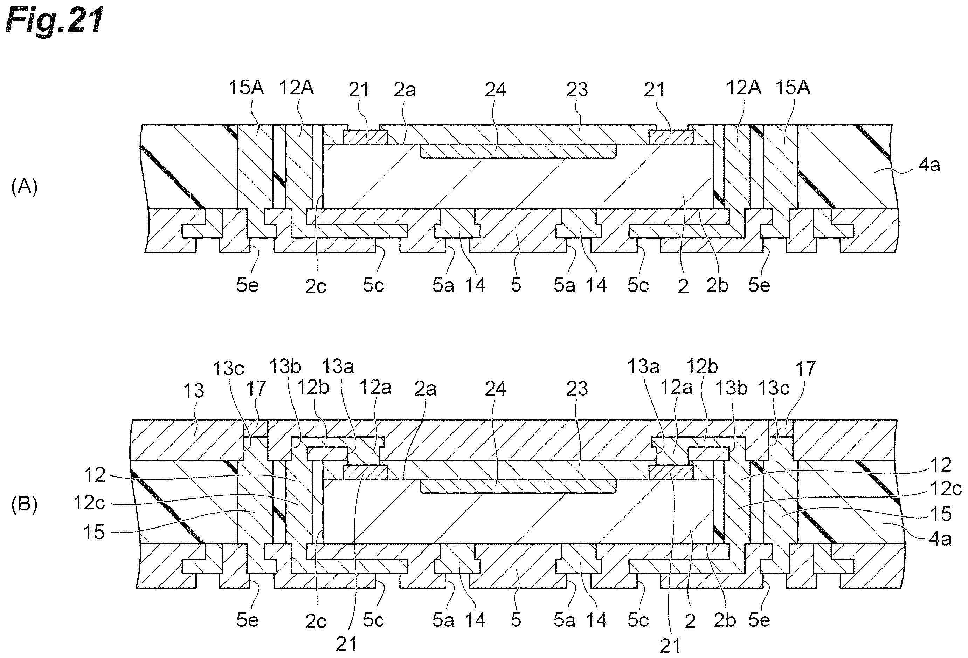

First, the first chip 2 and the first resin portion 4a in which a part (portion 12c) of the metal wiring 12 and a part of the metal wiring 15 are embedded are formed (first step). An example of the first step will be described with reference to FIGS. 19, 20, and (A) of FIG. 21. First, as illustrated in (A) of FIG. 19, for example, the substrate 50 such as a glass substrate, a silicon substrate, or an SUS substrate is prepared. A columnar metal member 12A including a portion to be a part (portion 12c) of the metal wiring 12 and a metal member 15A including a portion to be a part (portion surrounded by the first resin portion 4a) of the metal wiring 15 are temporarily bonded to the front surface 50a of the substrate 50 via a temporary bonding material. In addition, the first chip 2 is temporarily bonded to the front surface 50a of the substrate 50 via the temporary bonding material. The first chip 2 is temporarily bonded to the front surface 50a such that the inner surface 2a and the front surface 50a face each other. That is, the insulating layer 23 provided on the inner surface 2a of the first chip 2 is temporarily bonded to the front surface 50a.

Subsequently, as illustrated in (B) of FIG. 19, the first resin portion 4a is formed on the front surface 50a of the substrate 50 to seal the first chip 2 and the metal members 12A and 15A disposed on the substrate 50. At this point in time, the first resin portion 4a is formed to cover the outer surface 2b of the first chip 2.

Subsequently, as illustrated in (A) of FIG. 20, the first resin portion 4a, the first chip 2, and the metal members 12A and 15A are collectively polished or ground. Accordingly, after polishing or grinding, the outer surface 2b of the first chip 2, upper surfaces of the metal members 12A and 15A, and the front surface of the first resin portion 4a are substantially flush with each other, and the outer surface 2b of the first chip 2 and upper surfaces of the metal members 12A and 15A are exposed to the outside.

Subsequently, as illustrated in (B) of FIG. 20, the insulating layer 5 is formed on the outer surface 2b of the first chip 2, the upper surfaces of the metal members 12A and 15A, and the front surface of the first resin portion 4a, and the metal wiring 14, a part of the metal wiring 12 (a portion of the portion 12c disposed within the opening 5c of the insulating layer 5), and a part of the metal wiring 15 (a portion of the metal wiring 15 disposed within the opening 5e of the insulating layer 5) are formed. For example, from the state illustrated in (A) of FIG. 20, the structure illustrated in (B) of FIG. 20 is obtained by patterning the insulating layer 5 and patterning the metal wirings 12, 14, and 15 by using a semiconductor process (seed layer formation, photolithography, electrolytic plating, or the like).

Subsequently, as illustrated in (A) of FIG. 21, the substrate 50 provided on the inner surface 2a side of the first chip 2 is peeled off. As described above, the first step described above is completed.

Subsequently, as illustrated (B) of in FIG. 21, the insulating layer 13 on which the metal wiring 12 and the metal wiring 15 are provided is formed on the inner surface 2a of the first chip 2 and the first resin portion 4a (second step). That is, on the inner surface 2a (insulating layer 23) of the first chip 2 and the front surface of the first resin portion 4a, the insulating layer 13 is formed, and a part of the metal wiring 12 (mainly portion 12a and portion 12b) and a part of the metal wiring 15 are formed. For example, from the state illustrated in (A) of FIG. 21, patterning of the insulating layer 13 and patterning of the metal wirings 12 and 15 are performed by a semiconductor process (seed layer formation, photolithography, electrolytic plating, or the like). In addition, electroless plating is performed on the front surface of the end portion of the metal wiring 15 within the opening 13c, and thus, the plating portion 17 is formed within the opening 13c. As described above, the structure illustrated in (B) of FIG. 21 is obtained. Note that, in (B) of FIG. 21, although an outer surface of the plating portion 17 is flush with a front surface of the insulating layer 13, the outer surface of the plating portion 17 may be positioned within the opening 13c or may protrude outward from the front surface of the insulating layer 13.

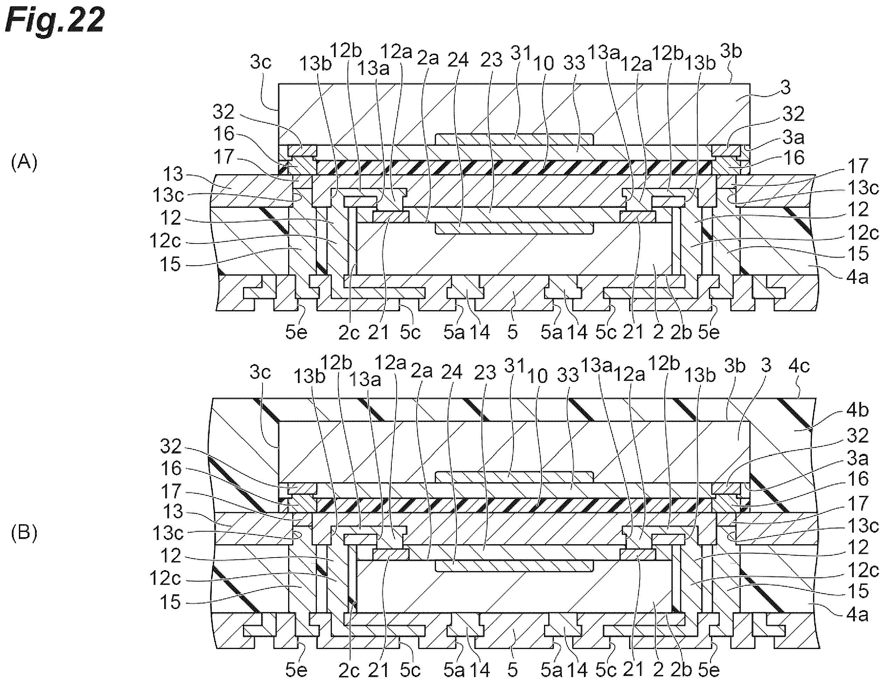

Subsequently, as illustrated in (A) of FIG. 22, the second chip 3 is disposed on the insulating layer 13 such that the terminal 32 of the second chip 3 and the plating portion 17 are electrically connected by the conductive bump 16 (third step). In addition, in the present embodiment, the underfill resin 10 is filled between the second chip 3 (insulating layer 33) and the insulating layer 13.

Subsequently, as illustrated in (B) of FIG. 22, the second resin portion 4b is formed after the third step (fourth step). In the present embodiment, the second resin portion 4b is formed to be continuous with the first resin portion 4a via the insulating layer 13. At this stage, the second resin portion 4b is formed to cover the outer surface 3b of the second chip 3. Note that, as described in the second embodiment, the end portion of the insulating layer 13 in the X-axis direction may be formed to be positioned inside an end portion of the optical semiconductor package 1C in the X-axis direction. In this case, the first resin portion 4a and the second resin portion 4b are integrally (continuously) provided in a region outside the end portion of the insulating layer 13 in the X-axis direction.

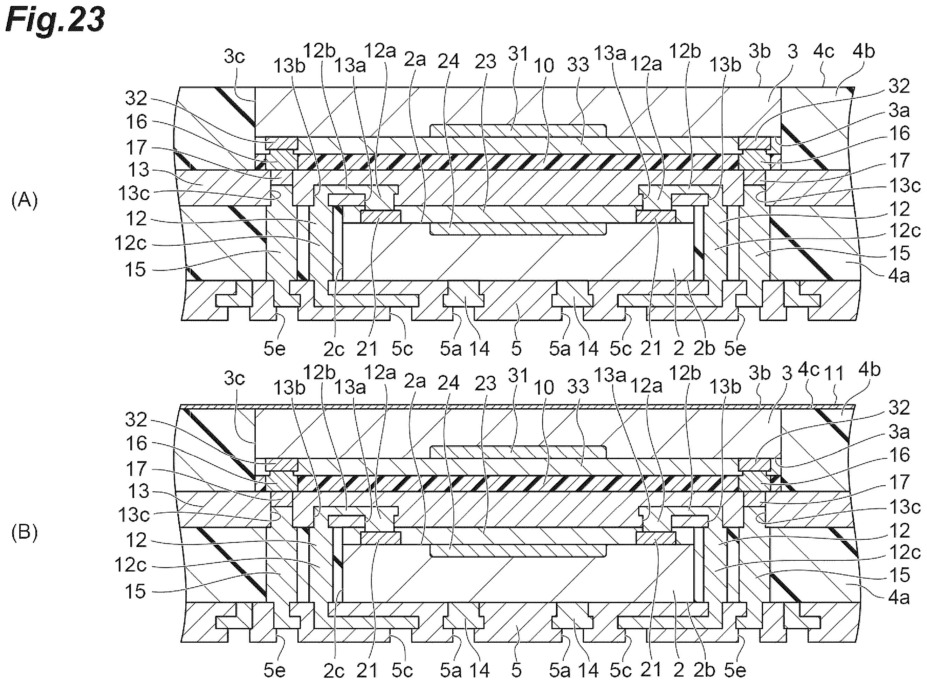

Subsequently, as illustrated in (A) of FIG. 23, a part on the outer surface 4c side of the second resin portion 4b is removed by polishing, grinding, or the like. At this time, the outer surface 4c of the second resin portion 4b and the outer surface 3b of the second chip 3 may be polished or ground together. As a result, as illustrated in (A) of FIG. 23, the second chip 3 is thinned, and the outer surface 3b of the second chip 3 is exposed to the outside. Accordingly, the outer surface 3b of the second chip 3 and the outer surface 4c of the second resin portion 4b are substantially flush with each other.

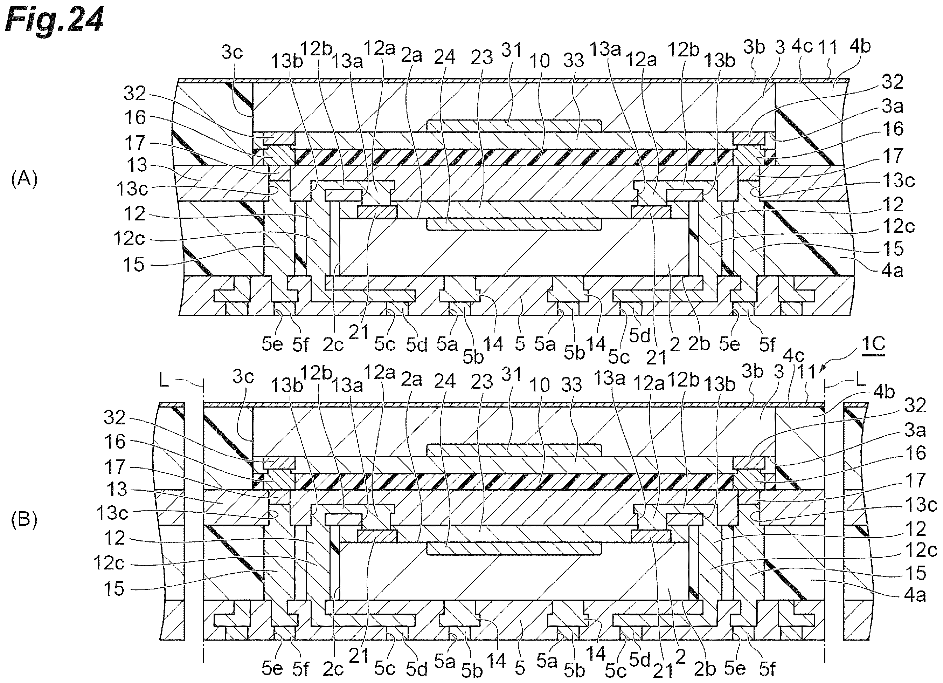

Subsequently, as illustrated in (B) of FIG. 23, the antireflection layer 11 is provided on the outer surface 3b of the second chip 3 and the outer surface 4c of the second resin portion 4b. In addition, as illustrated in (A) of FIG. 24, electroless plating is performed on the front surfaces of the metal wirings 14, 12, and 15 exposed to the openings 5a, 5c, and 5e of the insulating layer 5, and thus, the plating portions 5b, 5d, and 5f are formed within the openings 5a, 5c, and 5e. Subsequently, as illustrated in (B) of FIG. 24, dicing is performed along boundary lines L between the unit regions. Accordingly, a plurality of divided optical semiconductor packages 1C are obtained.

### (Effects)

Similarly to the optical semiconductor package 1B, in the optical semiconductor package 1C, the first resin portion 4a and the second resin portion 4b covering the side surfaces 2c and 3c of the first chip 2 and the second chip 3 disposed to be stacked in two stages are continuously provided via another member (insulating layer 13). That is, the first chip 2 and the second chip 3 are integrally fixed by the first resin portion 4a, the second resin portion 4b, and another member (insulating layer 13). Accordingly, the first chip 2 and the second chip 3 can be appropriately protected. In addition, as in the first embodiment, the electrode terminals (terminal 21 and terminal 32) of the first chip 2 and the second chip 3 are disposed in the region between the first chip 2 and the second chip 3. Accordingly, effects similar to the effects of the first embodiment can be obtained. That is, the reliability (fastness and stability of the light receiving function of the second chip 3) of the package can be improved.

In addition, the optical semiconductor package 1C includes the metal wiring 15 that is electrically connected to the terminal 32 of the second chip 3, passes through the inside of the first resin portion 4a, and extends from the inner surface 2a side to the outer surface 2b side in the Z-axis direction. According to the above configuration, the metal wiring 15 routed from the inner surface 3a (terminal 32) of the second chip 3 to the outer surface 2b side of the first chip 2 can be appropriately protected by the first resin portion 4a. Accordingly, the reliability of the optical semiconductor package 1C can be enhanced.

In addition, in the optical semiconductor package 1C, a width of the first chip 2 is smaller than a width of the second chip 3 in a width direction (the X-axis direction or the Y-axis direction) orthogonal to the Z-axis direction. In addition, the metal wirings 12 and 15 are disposed in the region overlapping the second chip 3 as viewed from the Z-axis direction. According to the above configuration, since the metal wirings 12 and 15 can be accommodated in the region overlapping the second chip 3 as viewed from the Z-axis direction, a size of the optical semiconductor package 1C in the width direction can be compact. Accordingly, the optical semiconductor package 1C can be downsized.

In addition, the second chip 3 is the light receiving element (first light receiving element) including the light receiving portion 31 (first light receiving portion) that receives the light incident on the outer surface 3b, and the first chip 2 is the light receiving element (second light receiving element) including the light receiving portion 24 (second light receiving portion) that receives the light transmitted through the second chip 3. According to the above configuration, the optical semiconductor package 1C having the structure in which the light receiving elements are disposed to be stacked in two stages can be realized in a highly reliable manner.

In addition, a method for producing the optical semiconductor package 1C includes the first step to the fourth step. According to the above producing method, it is possible to easily obtain the optical semiconductor package 1C with improved reliability in a structure in which two semiconductor chips are disposed to be stacked.

Note that, in the third embodiment, a structure similar to the structures of the first modification to the third modification of the first embodiment, and other modifications (omission of the underfill resin 10) can also be applied. In addition, in the third embodiment, the configuration in which the width of the first chip 2 is smaller than the width of the second chip 3 has been illustrated, the width of the first chip 2 may be the same as the width of the second chip 3 or may be larger than the width of the second chip 3. In a case where the width of the first chip 2 is equal to or smaller than the width of the second chip 3, the following effects are obtained. That is, in the optical semiconductor package 1C, it is necessary to route the metal wiring 12 and the metal wiring 15 to the side of the first chip 2. Thus, in a case where the width of the first chip 2 is larger than the width of the second chip 3, since the metal wiring 12 and the metal wiring 15 are positioned outside in the width direction (X-axis direction) by the width of the first chip 2, the size of the optical semiconductor package 1C may be increased. On the other hand, the width of the first chip 2 is equal to or smaller than the width of the second chip 3 as described above, and thus, it is possible to suppress the increase in size of the optical semiconductor package 1C described above.

### [Fourth Embodiment]

### (Structure of Optical Semiconductor Package)

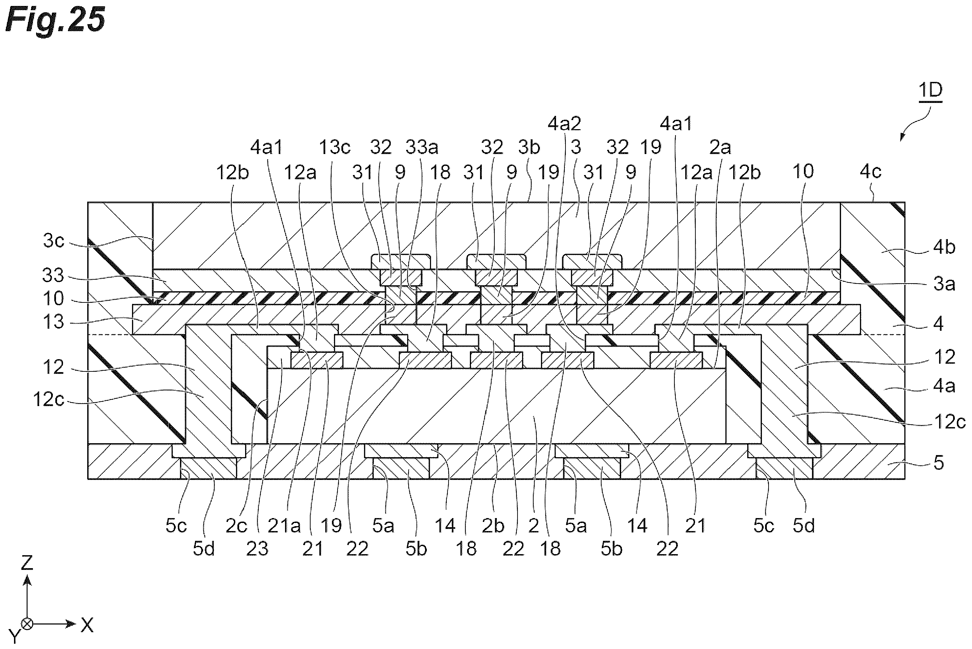

As illustrated in FIG. 25, an optical semiconductor package 1D of a fourth embodiment is different from the optical semiconductor package 1B mainly in that a metal wiring 18 (conductive member) for electrically connecting the first chip 2 and the second chip 3 is formed together with the metal wiring 12 by a semiconductor process. Hereinafter, portions of a configuration of the optical semiconductor package 1D different from the optical semiconductor package 1B will be described, and portions of the configuration of the optical semiconductor package 1D similar to the optical semiconductor package 1B will not be described.

In the optical semiconductor package 1D, the first resin portion 4a is formed to cover the insulating layer 23 of the first chip 2. In addition, the insulating layer 13 is provided on the first resin portion 4a. Openings 4a1 for exposing the terminals 21 and openings 4a2 for exposing the terminals 22 are formed in the first resin portion 4a on the insulating layer 23.

An end portion on the terminal 21 side of the metal wiring 12 is connected to the terminal 21 via the opening 4a1. In addition, the metal wiring 12 includes the portion 12a extending from the upper surface of the terminal 21 to the upper surface of the first resin portion 4a, the portion 12b extending from the end portion of the portion 12a to the outside of the side surface 2c of the first chip 2 along the upper surface of the first resin portion 4a, and the portion 12c extending from the end portion of the portion 12b to the opening 5c through the inside of the first resin portion 4a.

The opening 13c for exposing the metal wiring 18 electrically connected to the terminal 22 is provided in the insulating layer 13. A plating portion 19 is provided on a front surface of an end portion of the metal wiring 18 within the opening 13c. The plating portion 19 is, for example, two-layer plating of nickel and gold (Ni/Au plating). The plating portion 19 is electrically connected to the terminal 32 via the conductive bump 9. The underfill resin 10 is filled between the second chip 3 (insulating layer 33) and the insulating layer 13 to surround the conductive bump 9.

### (Method for Producing Optical Semiconductor Package)

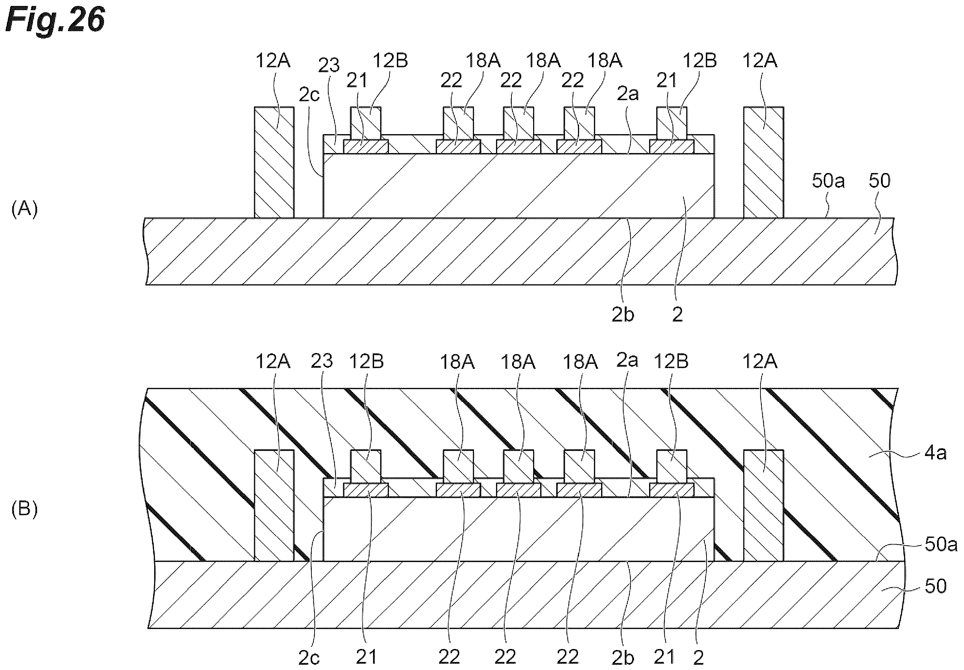

An example of a producing step of the optical semiconductor package 1D will be described with reference to FIGS. 26 to 29. In the present embodiment, the optical semiconductor package 1D is produced by a CoW method or a CoP method. FIGS. 26 to 29 illustrate a state of one unit region in each producing step. Hereinafter, description will be made focusing on only one unit region.

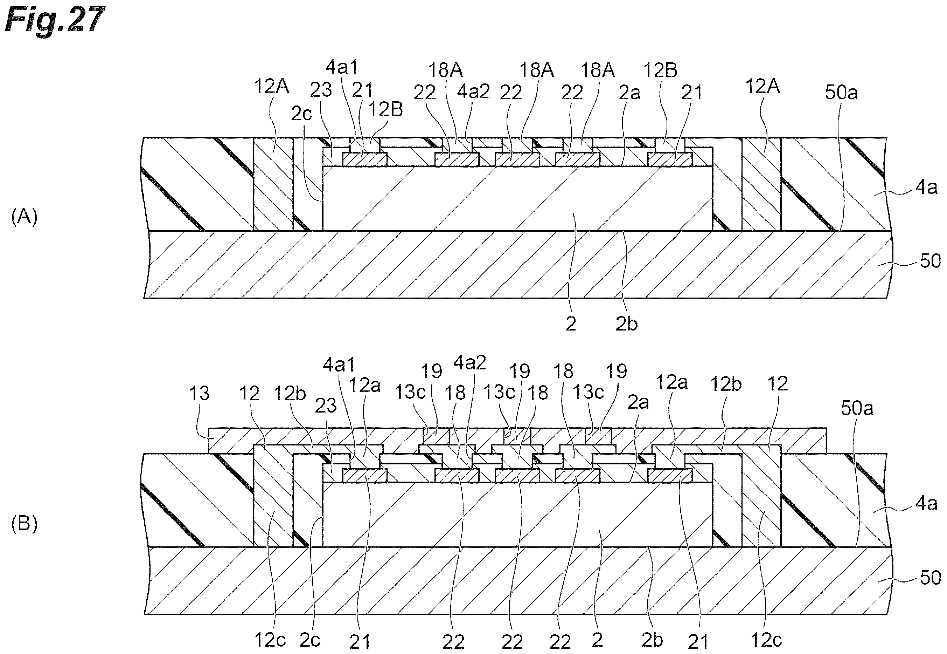

First, the substrate 50, the first chip 2 disposed on the substrate 50 such that the outer surface 2b faces the substrate 50, the first resin portion 4a formed to cover the inner surface 2a and the side surface 2c, and the metal wiring 12 and the metal wiring 18 disposed on the first resin portion 4a and within the first resin portion 4a are formed (first step). Subsequently, the insulating layer 13 in which the opening 13c for exposing the metal wiring 18 is provided is formed on the first resin portion 4a to cover the metal wiring 12 and the metal wiring 18 (second step). Examples of the first step and the second step will be described with reference to FIGS. 26 and 27.

First, as illustrated in (A) of FIG. 26, for example, the substrate 50 such as a glass substrate, a silicon substrate, or an SUS substrate is prepared. A columnar metal member 12A including a portion to be a part (portion 12c) of the metal wiring 12 is temporarily bonded to a front surface 50a of the substrate 50 via a temporary bonding material. In addition, the outer surface 2b of the first chip 2 is temporarily bonded to the front surface 50a of the substrate 50 via a temporary bonding material. Here, a columnar metal member 12B including a portion to be a part (portion 12a) of the metal wiring 12 is formed in advance on the terminal 21 of the first chip 2. In addition, a columnar metal member 18A including a portion to be a part of the metal wiring 18 is formed in advance on the terminal 22 of the first chip 2.

Subsequently, as illustrated in (B) of FIG. 26, the first resin portion 4a is formed on the front surface 50a of the substrate 50 to seal the first chip 2 and the metal members 12A, 12B, and 18A disposed on the substrate 50.

Subsequently, as illustrated in (A) of FIG. 27, the first resin portion 4a and the metal members 12A, 12B, and 18A are collectively polished or ground. Accordingly, after polishing or grinding, the front surface of the first resin portion 4a and the upper surfaces of the metal members 12A, 12B, and 18A are substantially flush with each other, and the upper surfaces of the metal members 12A, 12B, and 18A are exposed to the outside.

Subsequently, as illustrated in (B) of FIG. 27, on the front surface of the first resin portion 4a, the insulating layer 13 is formed, and the metal wirings 12 and 18 are formed. The insulating layer 13 is formed to cover the metal wiring 12. In addition, the opening 13c for exposing the metal wiring 18 is formed in the insulating layer 13. For example, from the state illustrated in (A) of FIG. 27, patterning of the insulating layer 13 and patterning of the metal wirings 12 and 18 are performed by a semiconductor process (seed layer formation, photolithography, electrolytic plating, or the like). In addition, electroless plating is performed on the front surface of the end portion of the metal wiring 18 within the opening 13c of the insulating layer 13, and thus, the plating portion 19 is formed within the opening 13c. Accordingly, the structure illustrated in (B) of FIG. 27 is obtained. As described above, the first step and the second step described above are completed.

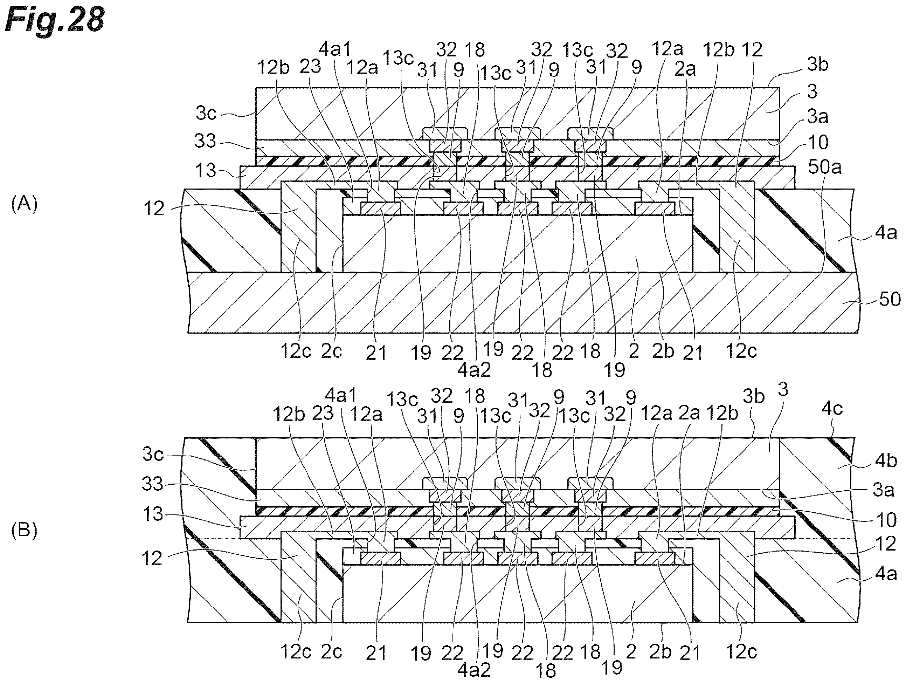

Subsequently, as illustrated in (A) of FIG. 28, the second chip 3 is disposed on the insulating layer 13 such that the terminal 32 of the second chip 3 and the metal wiring 18 are electrically connected via the opening 13c of the insulating layer 13 (third step). In the present embodiment, the second chip 3 is disposed on the first chip 2 such that the terminal 32 and the plating portion 19 are electrically connected via the conductive bump 9. In addition, the underfill resin 10 is filled between the second chip 3 (insulating layer 33) and the insulating layer 13 to surround the conductive bump 9.

Subsequently, as illustrated in (B) of FIG. 28, the second resin portion 4b is formed after the third step (fourth step). The second resin portion 4b is formed by, for example, transfer molding. Accordingly, the second resin portion 4b is formed not to cover the outer surface 3b of the second chip 3 while covering the side surface 3c of the second chip 3. In addition, in the present embodiment, the end portion of the insulating layer 13 in the width direction is positioned inside the end portions of the first resin portion 4a and the second resin portion 4b in the width direction. In this case, the first resin portion 4a and the second resin portion 4b are integrally formed outside the end portion of the insulating layer 13 in the width direction. In addition, after the second resin portion 4b is formed, the substrate 50 is peeled off from the first chip 2 and the first resin portion 4a (fifth step).

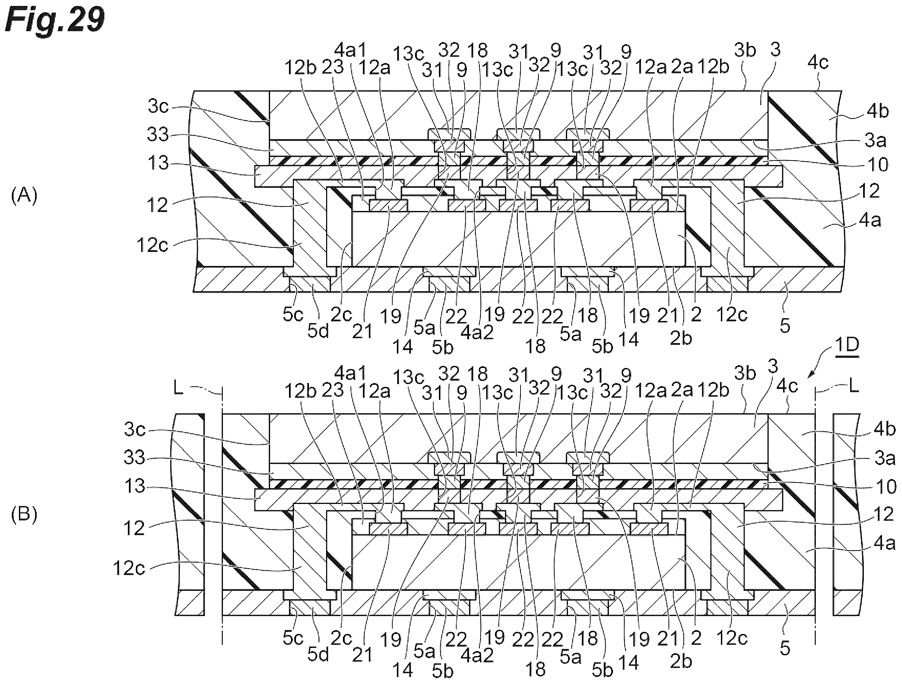

Subsequently, as illustrated in (A) of FIG. 29, on the outer surface 2b of the first chip 2 and the front surface of the first resin portion 4a, the insulating layer 5 is formed, and the metal wiring 14 and a part of the metal wiring 12 (a portion of the portion 12c disposed within the opening 5c of the insulating layer 5) are formed. For example, from the state illustrated in (B) of FIG. 29, the structure illustrated in (A) of FIG. 28 is obtained by patterning the insulating layer 5 and patterning the metal wirings 12 and 14 by using a semiconductor process (seed layer formation, photolithography, electrolytic plating, or the like). In addition, electroless plating is performed on the front surfaces of the metal wirings 14 and 12 exposed to the openings 5a and 5c of the insulating layer 5, and thus, the plating portions 5b and 5d are formed within the openings 5a and 5c. Subsequently, as illustrated in (B) of FIG. 29, dicing is performed along boundary lines L between the unit regions. Accordingly, a plurality of divided optical semiconductor packages 1D are obtained.

### (Effects)

In the optical semiconductor package 1D, the first resin portion 4a and the second resin portion 4b covering the side surfaces 2c and 3c of the first chip 2 and the second chip 3 disposed to be stacked in two stages are continuously provided via another member (insulating layer 13). In addition, the first resin portion 4a and the second resin portion 4b are integrally formed outside the insulating layer 13 in the width direction. That is, the first chip 2 and the second chip 3 are integrally fixed by the first resin portion 4a, the second resin portion 4b, and another member (insulating layer 13). Accordingly, the first chip 2 and the second chip 3 can be appropriately protected. In addition, as in the first embodiment, the electrode terminals (terminal 21 and terminal 32) of the first chip 2 and the second chip 3 are disposed in the region between the first chip 2 and the second chip 3. Accordingly, effects similar to the effects of the first embodiment can be obtained. That is, the reliability (fastness and stability of the light receiving function of the second chip 3) of the package can be improved.

In addition, the method for producing the optical semiconductor package 1D includes the first step to the fifth step. According to the above producing method, it is possible to easily obtain the optical semiconductor package 1D with improved reliability in a structure in which two semiconductor chips are disposed to be stacked.

Note that, in the fourth embodiment, a structure similar to the structures of the first modification to the fourth modification of the first embodiment described above, and other modifications can also be applied. In addition, in the fourth embodiment, the back surface wiring (that is, the insulating layer 5 and the metal wirings 12 and 18) of the first chip 2 is formed (see (A) of FIG. 29) after the resin molding step (that is, after the formation of the first resin portion 4a and the second resin portion 4b), but a back surface wiring may be formed first. That is, in the above-described producing step, the back surface wiring may be first formed on the front surface 50a of the substrate 50, and the first chip 2 may be disposed on the formed back surface wiring. Note that, the method for forming the back surface wiring first in this manner is also applicable to the embodiments (the first embodiment to the third embodiment and a fifth embodiment to be described later) other than the fourth embodiment.

### [Fifth Embodiment]

### (Structure of Optical Semiconductor Package)

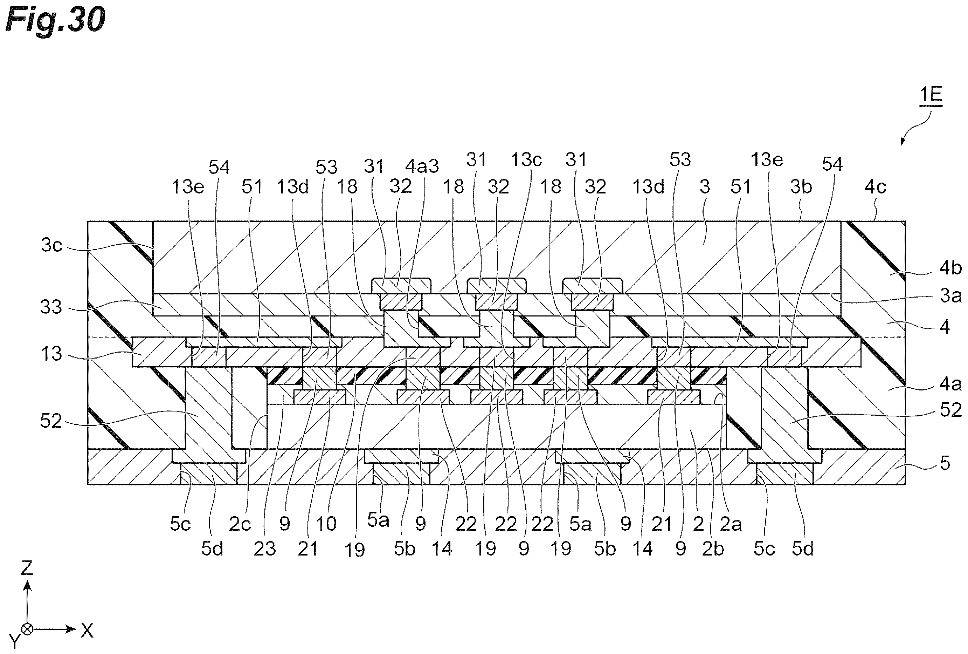

As illustrated in FIG. 30, an optical semiconductor package 1E of a fifth embodiment is different from the optical semiconductor package 1D mainly in that the metal wiring 18 (conductive member) for electrically connecting the first chip 2 and the second chip 3 is formed not on the first chip 2 side but on the second chip 3 side. In the optical semiconductor package 1D, the metal wiring 18, the plating portion 19, and the conductive bump 9 are formed in this order from the first chip 2 (terminal 22) side to the second chip 3 (terminal 32) side, but in the optical semiconductor package 1E, the metal wiring 18, the plating portion 19, and the conductive bump 9 are formed in this order from the second chip 3 (terminal 32) side to the first chip 2 (terminal 22) side. Hereinafter, portions of a configuration of the optical semiconductor package 1E different from the optical semiconductor package 1D will be described, and portions of the configuration of the optical semiconductor package 1E similar to the optical semiconductor package 1D will not be described.

In the optical semiconductor package 1E, the second resin portion 4b is formed to cover the insulating layer 33 of the second chip 3. In addition, the insulating layer 13 is provided on the second resin portion 4b (that is, a position on an opposite side of the insulating layer 33 with the second resin portion 4b interposed therebetween). Openings 4a3 for exposing the terminals 32 are formed in the second resin portion 4b on the insulating layer 33.

The opening 13c (third opening) for exposing the metal wiring 18 electrically connected to the terminal 32 is provided in the insulating layer 13. The plating portion 19 is provided on the front surface of the end portion (surface facing the terminal 22) of the metal wiring 18 within the opening 13c. The plating portion 19 is electrically connected to the terminal 22 via the conductive bump 9. The underfill resin 10 is filled between the first chip 2 (insulating layer 23) and the insulating layer 13 to surround the conductive bump 9.

In the optical semiconductor package 1E, instead of the metal wiring 12 of the optical semiconductor package 1D, a metal wiring 51 (a first portion of the first wiring) and a metal wiring 52 (a second portion of the first wiring) are provided as wirings for electrically connecting terminal 21 and the external device. An opening 13d (second opening) for exposing the terminal 21 is provided in the insulating layer 13. In addition, in the insulating layer 13, an opening 13e (first opening) penetrating from the first resin portion 4a side to the second resin portion 4b side is formed outside the side surface 2c of the first chip 2.

The metal wiring 51 extends in the width direction (X-axis direction) from the opening 13d to the opening 13e within the insulating layer 13 (a region of the insulating layer 13 along the second resin portion 4b). A plating portion 53 is provided on a front surface of the metal wiring 51 exposed to the first chip 2 side within the opening 13d. The plating portion 53 can be made of, for example, a material similar to the material of the plating portion 19. The plating portion 53 is electrically connected to the terminal 21 via the conductive bump 9 disposed between the plating portion 53 and the terminal 21. In addition, a plating portion 54 is provided on the front surface of the metal wiring 51 exposed to the first resin portion 4a side within the opening 13e. The plating portion 54 can be made of, for example, a material similar to the material of the plating portion 53. The metal wiring 52 is electrically connected to the plating portion 54, and extends in the Z-axis direction from the plating portion 54 to the opening 5c of the insulating layer 5. The plating portion 5d is provided on a front surface of an end portion of the metal wiring 52 within the opening 5c.

### (Method for Producing Optical Semiconductor Package)

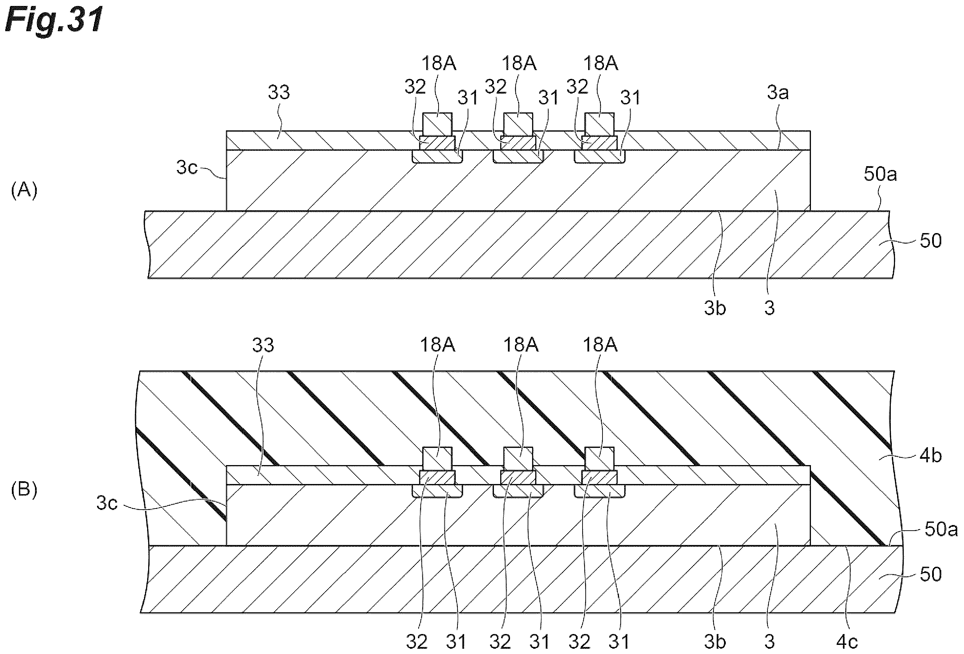

An example of a producing step of the optical semiconductor package 1E will be described with reference to FIGS. 31 to 35. In the present embodiment, the optical semiconductor package 1E is produced by a CoW method or a CoP method. FIGS. 31 to 35 illustrate a state of one unit region in each producing step. Hereinafter, description will be made focusing on only one unit region.

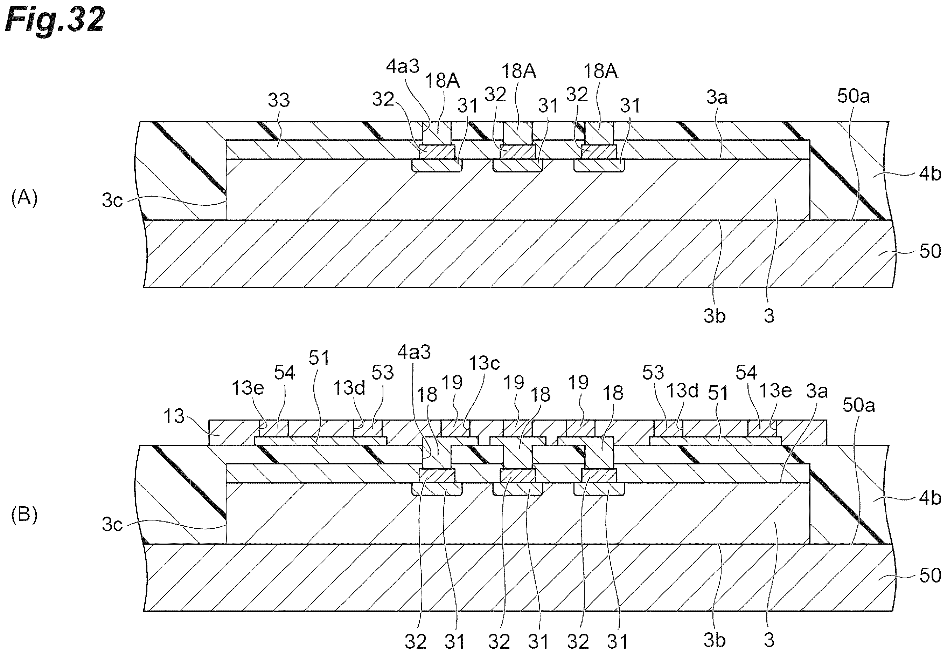

First, the substrate 50, the second chip 3 disposed on the substrate 50 such that the outer surface 3b faces the substrate 50, the second resin portion 4b formed to cover the inner surface 3a and the side surface 3c, and the metal wiring 51 and the metal wiring 18 disposed on the second resin portion 4b and within the second resin portion 4b are formed (first step). Subsequently, the insulating layer 13 on which the openings 13d and 13e for making contact with the metal wiring 51 and the opening 13c for making contact with the metal wiring 18 are provided is formed on the second resin portion 4b to cover the metal wiring 51 and the metal wiring 18 (second step). Examples of the first step and the second step will be described with reference to FIGS. 31 and 32.

First, as illustrated in (A) of FIG. 31, for example, the substrate 50 such as a glass substrate, a silicon substrate, or an SUS substrate is prepared. The outer surface 3b of the second chip 3 is temporarily bonded to the front surface 50a of the substrate 50 via the temporary bonding material. Here, a columnar metal member 18A including a portion to be a part of the metal wiring 18 is formed in advance on the terminal 32 of the second chip 3.

Subsequently, as illustrated in (B) of FIG. 31, the second resin portion 4b is formed on the front surface 50a of the substrate 50 to seal the second chip 3 and the metal member 18A disposed on the substrate 50.

Subsequently, as illustrated in (A) of FIG. 32, the second resin portion 4b and the metal member 18A are collectively polished or ground. Accordingly, after polishing or grinding, the front surface of the second resin portion 4b and the upper surface of the metal member 18A are substantially flush with each other, and the upper surface of the metal member 18A is exposed to the outside.

Subsequently, as illustrated in (B) of FIG. 32, on the front surface of the second resin portion 4b, the insulating layer 13 is formed, and the metal wirings 18 and 51 are formed. The insulating layer 13 is formed to cover the metal wirings 18 and 51. In addition, in the insulating layer 13, the opening 13c for exposing the metal wiring 18 and the openings 13d and 13e for exposing the metal wiring 51 are formed. For example, from the state illustrated in (A) of FIG. 32, the structure illustrated in (B) of FIG. 32 is obtained by patterning the insulating layer 13 and patterning the metal wirings 18 and 51 by using a semiconductor process (seed layer formation, photolithography, electrolytic plating, or the like). In addition, electroless plating is performed on the front surface of the end portion of the metal wiring 18 within the opening 13c of the insulating layer 13, and thus, the plating portion 19 is formed within the opening 13c. Similarly, electroless plating is performed on the front surface of the metal wiring 51 within the openings 13d and 13e of the insulating layer 13, and thus, the plating portions 53 and 54 are formed within the openings 13d and 13e. As described above, the first step and the second step described above are completed.

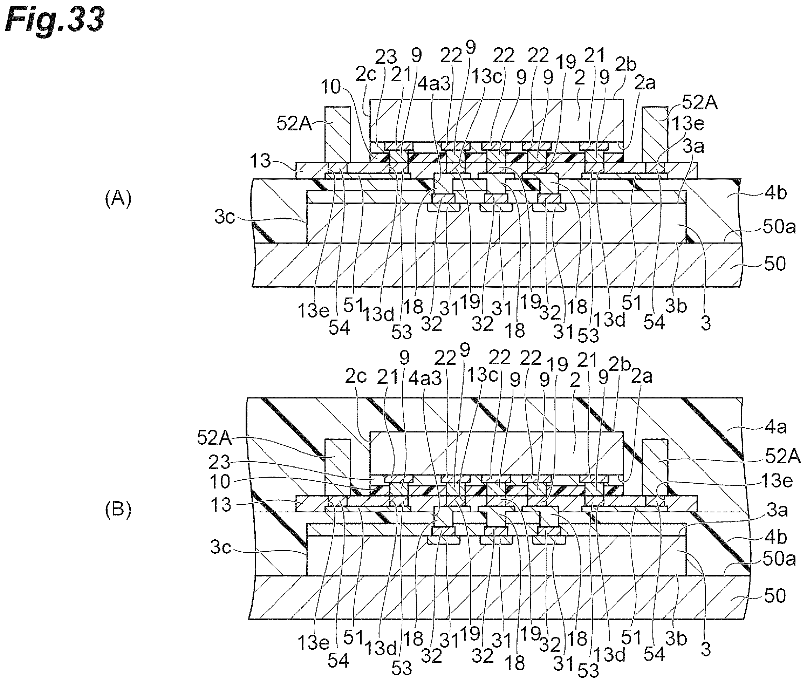

Subsequently, as illustrated in (A) of FIG. 33, the metal wiring 52 (here, a metal member 52A to be the metal wiring 52) electrically connected to the metal wiring 51 via the opening 13e is formed on the insulating layer 13 (third step). In addition, the first chip 2 is disposed on the insulating layer 13 such that the terminal 21 and the metal wiring 51 are electrically connected via the opening 13d and such that the terminal 22 and the metal wiring 18 are electrically connected via the opening 13c (fourth step). In the present embodiment, the terminal 21 and the plating portion 53 within the opening 13d are electrically connected via the conductive bump 9. In addition, the terminal 22 and the plating portion 19 within the opening 13c are electrically connected via the conductive bump 9. In addition, the underfill resin 10 is filled between the first chip 2 (insulating layer 23) and the insulating layer 13 to surround the conductive bump 9.

Subsequently, as illustrated in (B) of FIG. 33, the first resin portion 4a is formed after the fourth step (fifth step). In the present embodiment, the first resin portion 4a is formed to be continuous with the second resin portion 4b via the insulating layer 13. At this stage, the first resin portion 4a is formed to cover the outer surface 2b of the first chip 2. In addition, in the present embodiment, the end portion of the insulating layer 13 in the width direction is positioned inside the end portions of the first resin portion 4a and the second resin portion 4b in the width direction. In this case, the first resin portion 4a and the second resin portion 4b are integrally formed outside the end portion of the insulating layer 13 in the width direction.

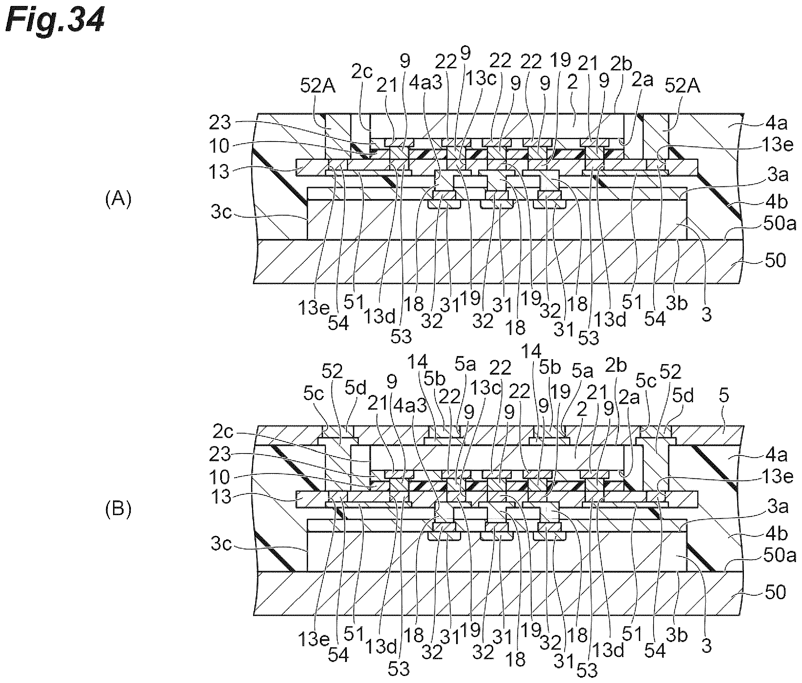

Subsequently, as illustrated in (A) of FIG. 34, the first resin portion 4a, the first chip 2, and the metal member 52A are collectively polished or ground. Accordingly, after polishing or grinding, the outer surface 2b of the first chip 2, the upper surface of the metal member 52A, and the front surface of the first resin portion 4a are substantially flush with each other, and the outer surface 2b of the first chip 2 and the upper surface of the metal member 52A are exposed to the outside.

Subsequently, as illustrated in (B) of FIG. 34, on the outer surface 2b of the first chip 2, the upper surface of the metal member 52A, and the front surface of the first resin portion 4a, the insulating layer 5 is formed, and the metal wiring 14 and a part of the metal wiring 52 (a portion of the metal wiring 52 disposed within the opening 5c of the insulating layer 5) are formed. For example, from the state illustrated in (A) of FIG. 34, patterning of the insulating layer 5 and patterning of the metal wirings 52 and 14 are performed by a semiconductor process (seed layer formation, photolithography, electrolytic plating, or the like). In addition, electroless plating is performed on the front surfaces of the metal wirings 14 and 52 exposed to the openings 5a and 5c of the insulating layer 5, and thus, the plating portions 5b and 5d are formed within the openings 5a and 5c. Accordingly, the structure illustrated in (B) of FIG. 34 is obtained.

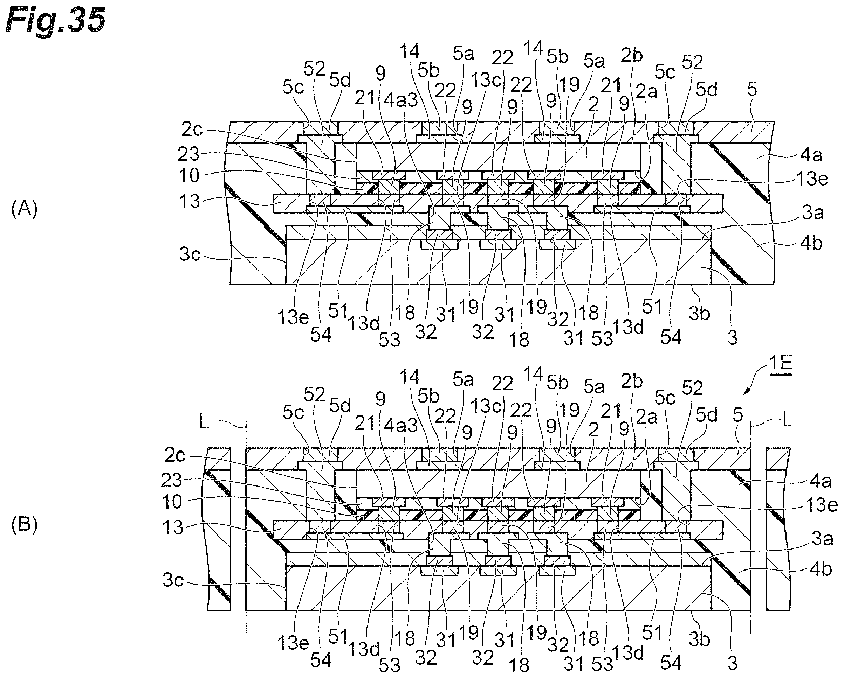

Subsequently, as illustrated in (A) of FIG. 35, the substrate 50 is peeled off from the outer surface 3b of the second chip 3 and the outer surface 4c of the second resin portion 4b (sixth step). Subsequently, as illustrated in (B) of FIG. 35, dicing is performed along boundary lines L between the unit regions. Accordingly, a plurality of divided optical semiconductor packages 1E are obtained.

### (Effects)

Similarly to the optical semiconductor package 1D, in the optical semiconductor package 1E, the first resin portion 4a and the second resin portion 4b covering the side surfaces 2c and 3c of the first chip 2 and the second chip 3 disposed to be stacked in two stages are continuously provided via another member (insulating layer 13). In addition, the first resin portion 4a and the second resin portion 4b are integrally formed outside the insulating layer 13 in the width direction. That is, the first chip 2 and the second chip 3 are integrally fixed by the first resin portion 4a, the second resin portion 4b, and another member (insulating layer 13). Accordingly, the first chip 2 and the second chip 3 can be appropriately protected. In addition, as in the first embodiment, the electrode terminals (terminal 21, terminal 22, and terminal 32) of the first chip 2 and the second chip 3 are disposed in the region between the first chip 2 and the second chip 3. Accordingly, effects similar to the effects of the first embodiment can be obtained. That is, the reliability (fastness and stability of the light receiving function of the second chip 3) of the package can be improved.

In addition, the method for producing the optical semiconductor package 1E includes the first step to the sixth step. According to the above producing method, it is possible to easily obtain the optical semiconductor package 1E with improved reliability in a structure in which two semiconductor chips are disposed to be stacked.

Note that, in the fifth embodiment, a structure similar to the structures of the first modification, the second modification, and the fourth modification of the first embodiment described above, and other modifications can also be applied.

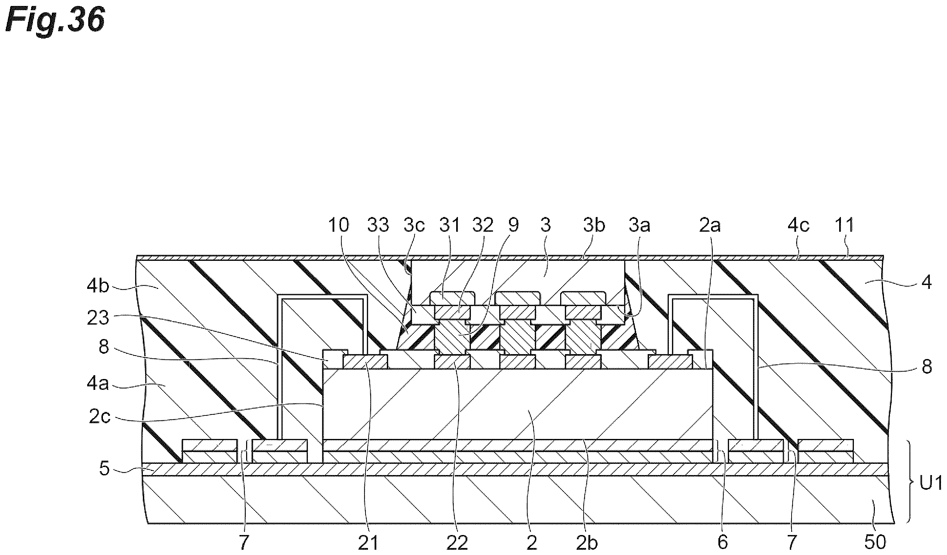

Although some embodiments of the present disclosure have been described above, the present disclosure is not limited to the above embodiments. The material and shape of each configuration are not limited to the material and shape described above, and various materials and shapes can be employed. In addition, a part of configurations in one embodiment or modification example described above can be arbitrarily applied to configurations in other embodiments or modification examples. For example, the order of the producing step of each embodiment may be appropriately changed. As an example, in the first embodiment, the step of removing the substrate 50 (sixth step) may be executed after polishing or the like of the molding resin 4 (or after the antireflection layer 11 is further formed) as illustrated in (A) of FIG. 5. In this case, as illustrated in FIG. 36, the substrate 50 remains without being removed in a state immediately after the molding resin 4 is polished (in this example, the antireflection layer 11 is further formed). In the present modification, thereafter, the substrate 50 is removed, and the openings 5a and 5c are formed. According to the present modification, it is possible to obtain an advantage that polishing or the like of the molding resin 4 can be performed with high reliability in a state where support stability of each member is enhanced by the substrate 50.

### Reference Signs List

- 1A, 1Aa, 1Ab, 1Ac, 1B, 1C, 1D, 1E: optical semiconductor package
- 2: first chip (first semiconductor chip)
- 2a: inner surface (first inner surface)
- 2b: outer surface (first outer surface)
- 2c: side surface (first side surface)
- 3: second chip (second semiconductor chip)
- 3a: inner surface (second inner surface)
- 3b: outer surface (second outer surface)
- 3c: side surface (second side surface)
- 4a: first resin portion
- 4b: second resin portion
- 5: insulating layer
- 5d: plating portion (contact portion)
- 8: wire (first wiring)
- 9: conductive bump (conductive member)
- 12: metal wiring (first wiring)
- 13: insulating layer (another member)
- 13c: opening (third opening)
- 13d: opening (second opening)
- 13e: opening (first opening)
- 15: metal wiring (second wiring)
- 18: metal wiring (conductive member)
- 21: terminal (first terminal)
- 22: terminal (third terminal)
- 24: light receiving portion (second light receiving portion)
- 31: light receiving portion (first light receiving portion)
- 32: terminal (second terminal)
- 50: substrate
- U1: substrate unit
- U2: chip unit

## Claims

1. An optical semiconductor package (1) comprising:
a first chip (2) being a semiconductor chip having a first inner surface (2a), a first outer surface (2b) being a surface on an opposite side of the first inner surface (2a), and a first side surface (2c) connecting the first inner surface (2a) and the first outer surface (2b);
a second chip (3) being a semiconductor chip disposed at a position facing the first inner surface (2a), the second chip (3) having a second inner surface (3a) facing the first inner surface (2a), a second outer surface (3b) being a surface on an opposite side of the second inner surface (3a), and a second side surface (3c) connecting the second inner surface (3a) and the second outer surface (3b);
a first resin portion (4a) formed to cover at least the first side surface (2c);
a second resin portion (4b) formed to cover at least the second side surface (3c);
a first terminal (21) being an electrode terminal of the first chip (2) and provided on the first inner surface (2a);
a second terminal (32) being an electrode terminal of the second chip (3) and provided on the second inner surface (3a); and
a first wiring (12) electrically connected to the first terminal (21), passing through an inside of the first resin portion (4a), and extending from the first inner surface side to the first outer surface side in a facing direction in which the first inner surface (2a) and the second inner surface (3a) face each other, wherein
the second chip (3) is an optical element having a light receiving portion which receives light incident on the second outer surface (3b) or a light emitting portion which generates light emitted from the second outer surface (3b) to an outside,
the first resin portion (4a) and the second resin portion (4b) are integrally provided or continuously provided via another member (13), and
the second outer surface (3b) is not covered with the second resin portion (4b).

2. The optical semiconductor package (1) according to claim 1, further comprising:
an insulating layer (5) covering the first outer surface (2b) of the first chip (2); and
a contact portion (5d) provided to be exposed to an opposite side to the first chip side of the insulating layer (5), and electrically connected to the first terminal (21).

3. The optical semiconductor package (1) according to claim 1 or 2, wherein the second outer surface (3b) is positioned closer to the first chip (2) than a surface of the second resin portion (4b) on an opposite side to the first resin portion (4a) in the facing direction.

4. The optical semiconductor package (1) according to any one of claims 1 to 3, further comprising:
a third terminal (22) being an electrode terminal of the first chip (2) and provided on the first inner surface (2a); and
a conductive member (9) disposed between the first chip (2) and the second chip (3) to electrically connect the second terminal (32) and the third terminal (22).

5. The optical semiconductor package (1) according to any one of claims 1 to 3, further comprising:
a second wiring (15) electrically connected to the second terminal (32), passing through the inside of the first resin portion (4a), and extending from the first inner surface side to the first outer surface side in the facing direction.

6. The optical semiconductor package (1) according to claim 5, wherein
a width of the first chip (2) is smaller than or equal to a width of the second chip (3) in a width direction orthogonal to the facing direction.

7. The optical semiconductor package (1) according to claim 5, wherein
a width of the first chip (2) is smaller than a width of the second chip (3) in a width direction orthogonal to the facing direction, and
the first wiring (12) and the second wiring (15) are disposed within a region overlapping the second chip (3) as viewed from the facing direction.

8. The optical semiconductor package (1) according to any one of claims 5 to 7, wherein
the second chip (3) is a first light receiving element having a first light receiving portion (31) that receives light incident on the second outer surface (3b), and
the first chip (2) is a second light receiving element having a second light receiving portion (24) that receives light transmitted through the second chip (3).

9. A method for producing the optical semiconductor package (1) according to claim 4, the method comprising;
a first step of forming a substrate unit including a substrate (50) and a first electrode and a second electrode provided on the substrate (50);
a second step of forming a chip unit including the first chip (2) and the second chip (3), the chip unit being in a state where the second terminal (32) and the third terminal (22) are electrically connected by the conductive member (9);
a third step of mounting the chip unit on the substrate unit by bonding the first outer surface (2b) to the first electrode;
a fourth step of forming the first wiring (12) by wire-bonding the first terminal (21) and the second electrode;
a fifth step of integrally forming the first resin portion (4a) and the second resin portion (4b); and
a sixth step of removing the substrate (50).

10. A method for producing the optical semiconductor package (1) according to claim 4, the method comprising:
a first step of forming the first chip (2) and the first resin portion (4a) in which a part of the first wiring (12) is embedded;
a second step of forming an insulating layer (5) provided with the first wiring (12) around the first terminal (21) on the first inner surface (2a) and on the first resin portion (4a);
a third step of disposing the second chip (3) on the first chip (2) such that the second terminal (32) and the third terminal (22) are electrically connected by the conductive member (9); and
a fourth step of forming the second resin portion (4b) after the third step.

11. A method for producing the optical semiconductor package (1) according to claim 5, the method comprising:
a first step of forming the first chip (2) and the first resin portion (4a) in which a part of the first wiring (12) and the second wiring (15) is embedded;
a second step of forming an insulating layer (5) provided with the first wiring (12) and the second wiring (15), on the first inner surface (2a) and the first resin portion (4a);
a third step of disposing the second chip (3) on the insulating layer (5) such that an end portion of the second wiring (15) and the second terminal (32) are electrically connected; and
a fourth step of forming the second resin portion (4b) after the third step.

12. A method for producing the optical semiconductor package (1) according to claim 4, the method comprising:
a first step of forming a substrate (50), the first chip (2) disposed on the substrate (50) such that the first outer surface (2b) faces the substrate (50), the first resin portion (4a) formed to cover the first inner surface (2a) and the first side surface (2c), and the first wiring (12) and the conductive member (9) disposed on the first resin portion (4a) and within the first resin portion (4a);
a second step of forming an insulating layer (5) in which an opening for exposing the conductive member (9) is provided, on the first resin portion (4a), to cover the first wiring (12) and the conductive member (9);
a third step of disposing the second chip (3) on the insulating layer (5) such that the second terminal (32) and the conductive member (9) are electrically connected via the opening of the insulating layer (5);
a fourth step of forming the second resin portion (4b) after the third step; and
a fifth step of peeling off the substrate (50) from the first chip (2) and the first resin portion (4a).

13. A method for producing the optical semiconductor package (1) according to claim 4, the method comprising:
a first step of forming a substrate (50), a second chip (3) disposed on the substrate (50) such that the second outer surface (3b) faces the substrate (50), the second resin portion (4b) formed to cover the second inner surface (3a) and the second side surface (3c), and a first portion of the first wiring (12) and the conductive member (9) disposed on the second resin portion (4b) and within the second resin portion (4b);
a second step of forming an insulating layer (5) in which a first opening (13e) and a second opening (13d) for making contact with the first portion and a third opening (13c) for making contact with the conductive member (9) are provided, on the second resin portion (4b), to cover the first portion and the conductive member (9);
a third step of forming a second portion of the first wiring (12) electrically connected to the first portion via the first opening (13e) on the insulating layer (5);
a fourth step of disposing the first chip (2) on the insulating layer (5) such that the first terminal (21) and the first portion are electrically connected via the second opening (13d) and such that the third terminal (22) and the conductive member (9) are electrically connected via the third opening (13c);
a fifth step of forming the first resin portion (4a) after the fourth step; and
a sixth step of peeling off the substrate (50) from the second chip (3) and the second resin portion (4b).

14. The method for producing the optical semiconductor package (1) according to any one of claims 9 to 13, wherein
the second resin portion (4b) is formed not to cover the second outer surface (3b).

15. The method for producing the optical semiconductor package (1) according to claim 14, further comprising:
a step of removing a part on the second outer surface side of the second chip (3) such that the second outer surface (3b) is positioned closer to the first chip (2) than a surface of the second resin portion (4b) on an opposite side to the first resin portion (4a).

## Patentansprüche

1. Optisches Halbleitergehäuse (1), umfassend:
einen ersten Chip (2), der ein Halbleiterchip ist und eine erste Innenfläche (2a), eine erste Außenfläche (2b), die eine Fläche auf einer der ersten Innenfläche (2a) gegenüberliegenden Seite ist, und eine erste Seitenfläche (2c), die die erste Innenfläche (2a) und die erste Außenfläche (2b) verbindet, aufweist;
einen zweiten Chip (3), der ein Halbleiterchip ist, der an einer Position angeordnet ist, die der ersten Innenfläche (2a) gegenüberliegt, wobei der zweite Chip (3) eine zweite Innenfläche (3a), die der ersten Innenfläche (2a) gegenüberliegt, eine zweite Außenfläche (3b), die eine Fläche auf einer der zweiten Innenfläche (3a) gegenüberliegenden Seite ist, und eine zweite Seitenfläche (3c), die die zweite Innenfläche (3a) und die zweite Außenfläche (3b) verbindet, aufweist;
einen ersten Harzabschnitt (4a), der so gebildet ist, dass er mindestens die erste Seitenfläche (2c) bedeckt;
einen zweiten Harzabschnitt (4b), der so gebildet ist, dass er mindestens die zweite Seitenfläche (3c) bedeckt;
einen ersten Anschluss (21), der ein Elektrodenanschluss des ersten Chips (2) ist und auf der ersten Innenfläche (2a) vorgesehen ist;
einen zweiten Anschluss (32), der ein Elektrodenanschluss des zweiten Chips (3) ist und auf der zweiten Innenfläche (3a) vorgesehen ist; und
eine erste Verdrahtung (12), die mit dem ersten Anschluss (21) elektrisch verbunden ist, durch ein Inneres des ersten Harzabschnitts (4a) hindurchgeht und sich in einer Gegenüberstellungsrichtung, in der die erste Innenfläche (2a) und die zweite Innenfläche (3a) einander gegenüberliegen, von der ersten Innenflächenseite zu der ersten Außenflächenseite erstreckt, wobei
der zweite Chip (3) ein optisches Element ist, das einen Lichtempfangsabschnitt, der auf die zweite Außenfläche (3b) einfallendes Licht empfängt, oder einen Lichtaussendeabschnitt, der Licht erzeugt, das von der zweiten Außenfläche (3b) nach außen ausgesendet wird, aufweist,
der erste Harzabschnitt (4a) und der zweite Harzabschnitt (4b) integral vorgesehen sind oder über ein anderes Element (13) kontinuierlich vorgesehen sind, und
die zweite Außenfläche (3b) nicht mit dem zweiten Harzabschnitt (4b) bedeckt ist.

2. Optisches Halbleitergehäuse (1) nach Anspruch 1, weiter umfassend:
eine Isolierschicht (5), die die erste Außenfläche (2b) des ersten Chips (2) bedeckt; und
einen Kontaktabschnitt (5d), der so vorgesehen ist, dass er zu einer der ersten Chip-Seite der Isolierschicht (5) gegenüberliegenden Seite freiliegt, und der mit dem ersten Anschluss (21) elektrisch verbunden ist.

3. Optisches Halbleitergehäuse (1) nach Anspruch 1 oder 2, wobei die zweite Außenfläche (3b) näher zu dem ersten Chip (2) positioniert ist als eine Fläche des zweiten Harzabschnitts (4b) auf einer dem ersten Harzabschnitt (4a) gegenüberliegenden Seite in der Gegenüberstellungsrichtung.

4. Optisches Halbleitergehäuse (1) nach einem der Ansprüche 1 bis 3, weiter umfassend:
einen dritten Anschluss (22), der ein Elektrodenanschluss des ersten Chips (2) ist und auf der ersten Innenfläche (2a) vorgesehen ist; und
ein leitfähiges Element (9), das zwischen dem ersten Chip (2) und dem zweiten Chip (3) angeordnet ist, um den zweiten Anschluss (32) und den dritten Anschluss (22) elektrisch zu verbinden.

5. Optisches Halbleitergehäuse (1) nach einem der Ansprüche 1 bis 3, weiter umfassend:
eine zweite Verdrahtung (15), die mit dem zweiten Anschluss (32) elektrisch verbunden ist, durch das Innere des ersten Harzabschnitts (4a) hindurchgeht und sich in der Gegenüberstellungsrichtung von der ersten Innenflächenseite zu der ersten Außenflächenseite erstreckt.

6. Optisches Halbleitergehäuse (1) nach Anspruch 5, wobei
eine Breite des ersten Chips (2) kleiner als oder gleich einer Breite des zweiten Chips (3) in einer zu der Gegenüberstellungsrichtung orthogonalen Breitenrichtung ist.

7. Optisches Halbleitergehäuse (1) nach Anspruch 5, wobei
eine Breite des ersten Chips (2) kleiner als eine Breite des zweiten Chips (3) in einer zu der Gegenüberstellungsrichtung orthogonalen Breitenrichtung ist, und
die erste Verdrahtung (12) und die zweite Verdrahtung (15) innerhalb eines Bereichs angeordnet sind, der bei Ansicht in der Gegenüberstellungsrichtung den zweiten Chip (3) überlappt.

8. Optisches Halbleitergehäuse (1) nach einem der Ansprüche 5 bis 7, wobei
der zweite Chip (3) ein erstes Lichtempfangselement ist, das einen ersten Lichtempfangsabschnitt (31) aufweist, der auf die zweite Außenfläche (3b) einfallendes Licht empfängt, und
der erste Chip (2) ein zweites Lichtempfangselement ist, das einen zweiten Lichtempfangsabschnitt (24) aufweist, der Licht empfängt, das durch den zweiten Chip (3) übertragen wird.

9. Verfahren zur Herstellung des optischen Halbleitergehäuses (1) nach Anspruch 4, wobei das Verfahren umfasst;
einen ersten Schritt des Bildens einer Substrateinheit, die ein Substrat (50) und eine erste Elektrode und eine zweite Elektrode einschließt, die auf dem Substrat (50) vorgesehen sind;
einen zweiten Schritt des Bildens einer Chipeinheit, die den ersten Chip (2) und den zweiten Chip (3) einschließt, wobei die Chipeinheit in einem Zustand ist, in dem der zweite Anschluss (32) und der dritte Anschluss (22) durch das leitfähige Element (9) elektrisch verbunden sind;
einen dritten Schritt des Montierens der Chipeinheit auf der Substrateinheit durch Bonden der ersten Außenfläche (2b) an die erste Elektrode;
einen vierten Schritt des Bildens der ersten Verdrahtung (12) durch Drahtbonden des ersten Anschlusses (21) und der zweiten Elektrode;
einen fünften Schritt des integralen Bildens des ersten Harzabschnitts (4a) und des zweiten Harzabschnitts (4b); und
einen sechsten Schritt des Entfernens des Substrats (50).

10. Verfahren zur Herstellung des optischen Halbleitergehäuses (1) nach Anspruch 4, wobei das Verfahren umfasst:
einen ersten Schritt des Bildens des ersten Chips (2) und des ersten Harzabschnitts (4a), in den ein Teil der ersten Verdrahtung (12) eingebettet ist;
einen zweiten Schritt des Bildens einer Isolierschicht (5), die mit der ersten Verdrahtung (12) um den ersten Anschluss (21) herum auf der ersten Innenfläche (2a) und auf dem ersten Harzabschnitt (4a) vorgesehen ist;
einen dritten Schritt des Anordnens des zweiten Chips (3) auf dem ersten Chip (2), so dass der zweite Anschluss (32) und der dritte Anschluss (22) durch das leitfähige Element (9) elektrisch verbunden sind; und
einen vierten Schritt des Bildens des zweiten Harzabschnitts (4b) nach dem dritten Schritt.

11. Verfahren zur Herstellung des optischen Halbleitergehäuses (1) nach Anspruch 5, wobei das Verfahren umfasst:
einen ersten Schritt des Bildens des ersten Chips (2) und des ersten Harzabschnitts (4a), in den ein Teil der ersten Verdrahtung (12) und der zweiten Verdrahtung (15) eingebettet ist;
einen zweiten Schritt des Bildens einer Isolierschicht (5), die mit der ersten Verdrahtung (12) und der zweiten Verdrahtung (15) versehen ist, auf der ersten Innenfläche (2a) und dem ersten Harzabschnitt (4a);
einen dritten Schritt des Anordnens des zweiten Chips (3) auf der Isolierschicht (5), so dass ein Endabschnitt der zweiten Verdrahtung (15) und der zweite Anschluss (32) elektrisch verbunden sind; und
einen vierten Schritt des Bildens des zweiten Harzabschnitts (4b) nach dem dritten Schritt.

12. Verfahren zur Herstellung des optischen Halbleitergehäuses (1) nach Anspruch 4, wobei das Verfahren umfasst:
einen ersten Schritt des Bildens eines Substrats (50), wobei der erste Chip (2) auf dem Substrat (50) so angeordnet ist, dass die erste Außenfläche (2b) dem Substrat (50) gegenüberliegt, der erste Harzabschnitt (4a) so gebildet ist, dass er die erste Innenfläche (2a) und die erste Seitenfläche (2c) bedeckt, und die erste Verdrahtung (12) und das leitfähige Element (9) auf dem ersten Harzabschnitt (4a) und innerhalb des ersten Harzabschnitts (4a) angeordnet sind;
einen zweiten Schritt des Bildens einer Isolierschicht (5), in der eine Öffnung zum Freilegen des leitfähigen Elements (9) vorgesehen ist, auf dem ersten Harzabschnitt (4a), um die erste Verdrahtung (12) und das leitfähige Element (9) zu bedecken;
einen dritten Schritt des Anordnens des zweiten Chips (3) auf der Isolierschicht (5), so dass der zweite Anschluss (32) und das leitfähige Element (9) über die Öffnung der Isolierschicht (5) elektrisch verbunden sind;
einen vierten Schritt des Bildens des zweiten Harzabschnitts (4b) nach dem dritten Schritt; und
einen fünften Schritt des Abziehens des Substrats (50) von dem ersten Chip (2) und dem ersten Harzabschnitt (4a).

13. Verfahren zur Herstellung des optischen Halbleitergehäuses (1) nach Anspruch 4, wobei das Verfahren umfasst:
einen ersten Schritt des Bildens eines Substrats (50), wobei ein zweiter Chip (3) auf dem Substrat (50) so angeordnet ist, dass die zweite Außenfläche (3b) dem Substrat (50) gegenüberliegt, der zweite Harzabschnitt (4b) so gebildet ist, dass er die zweite Innenfläche (3a) und die zweite Seitenfläche (3c) bedeckt, und ein erster Abschnitt der ersten Verdrahtung (12) und das leitfähige Element (9) auf dem zweiten Harzabschnitt (4b) und innerhalb des zweiten Harzabschnitts (4b) angeordnet sind;
einen zweiten Schritt des Bildens einer Isolierschicht (5), in der eine erste Öffnung (13e) und eine zweite Öffnung (13d) zum Herstellen eines Kontakts mit dem ersten Abschnitt und eine dritte Öffnung (13c) zum Herstellen eines Kontakts mit dem leitfähigen Element (9) vorgesehen sind, auf dem zweiten Harzabschnitt (4b), um den ersten Abschnitt und das leitfähige Element (9) zu bedecken;
einen dritten Schritt des Bildens eines zweiten Abschnitts der ersten Verdrahtung (12), der über die erste Öffnung (13e) auf der Isolierschicht (5) mit dem ersten Abschnitt elektrisch verbunden ist;
einen vierten Schritt des Anordnens des ersten Chips (2) auf der Isolierschicht (5), so dass der erste Anschluss (21) und der erste Abschnitt über die zweite Öffnung (13d) elektrisch verbunden sind und so dass der dritte Anschluss (22) und das leitfähige Element (9) über die dritte Öffnung (13c) elektrisch verbunden sind;
einen fünften Schritt des Bildens des ersten Harzabschnitts (4a) nach dem vierten Schritt; und
einen sechsten Schritt des Abziehens des Substrats (50) von dem zweiten Chip (3) und dem zweiten Harzabschnitt (4b).

14. Verfahren zur Herstellung des optischen Halbleitergehäuses (1) nach einem der Ansprüche 9 bis 13, wobei
der zweite Harzabschnitt (4b) so gebildet ist, dass er die zweite Außenfläche (3b) nicht bedeckt.

15. Verfahren zur Herstellung des optischen Halbleitergehäuses (1) nach Anspruch 14, weiter umfassend:
einen Schritt des Entfernens eines Teils auf der zweiten Außenflächenseite des zweiten Chips (3), so dass die zweite Außenfläche (3b) näher am ersten Chip (2) positioniert ist als eine Fläche des zweiten Harzabschnitts (4b) auf einer dem ersten Harzabschnitt (4a) gegenüberliegenden Seite.

## Revendications

1. Boîtier de semi-conducteur optique (1) comprenant :
une première puce (2) qui est une puce semi-conductrice présentant une première surface interne (2a), une première surface externe (2b) qui est une surface sur un côté opposé de la première surface interne (2a), et une première surface latérale (2c) reliant la première surface interne (2a) à la première surface externe (2b) ;
une seconde puce (3) qui est une puce semi-conductrice disposée au niveau d'une position faisant face à la première surface interne (2a), la seconde puce (3) présentant une seconde surface interne (3a) faisant face à la première surface interne (2a), une seconde surface externe (3b) qui est une surface située sur un côté opposé de la seconde surface interne (3a), et une seconde surface latérale (3c) reliant la seconde surface interne (3a) à la seconde surface externe (3b) ;
une première partie de résine (4a) formée pour recouvrir au moins la première surface latérale (2c) ;
une seconde partie de résine (4b) formée pour recouvrir au moins la seconde surface latérale (3c) ;
une première borne (21) qui est une borne d'électrode de la première puce (2) et disposée sur la première surface interne (2a) ;
une deuxième borne (32) qui est une borne d'électrode de la seconde puce (3) et disposée sur la seconde surface interne (3a) ; et
un premier câblage (12) électriquement connecté à la première borne (21), passant à travers un intérieur de la première partie de résine (4a), et s'étendant du côté de la première surface interne vers le côté de la première surface externe dans une direction de face à face dans laquelle la première surface interne (2a) et la seconde surface interne (3a) se font face, dans lequel
la seconde puce (3) est un élément optique présentant une partie de réception de lumière qui reçoit une lumière incidente sur la seconde surface externe (3b) ou une partie d'émission de lumière qui génère une lumière émise depuis la seconde surface externe (3b) vers un extérieur,
la première partie de résine (4a) et la seconde partie de résine (4b) sont disposées d'un seul tenant ou disposées de manière continue via un autre élément (13), et
la seconde surface externe (3b) n'est pas recouverte par la seconde partie de résine (4b).

2. Boîtier de semi-conducteur optique (1) selon la revendication 1, comprenant en outre :
une couche isolante (5) recouvrant la première surface externe (2b) de la première puce (2) ; et
une partie de contact (5d) disposée pour être exposée à un côté opposé au côté de la première puce de la couche isolante (5), et électriquement connectée à la première borne (21).

3. Boîtier de semi-conducteur optique (1) selon la revendication 1 ou la revendication 2, dans lequel la seconde surface externe (3b) est positionnée plus près de la première puce (2) qu'une surface de la seconde partie de résine (4b) sur un côté opposé à la première partie de résine (4a) dans la direction de face à face.

4. Boîtier de semi-conducteur optique (1) selon l'une quelconque des revendications 1 à 3, comprenant en outre :
une troisième borne (22) qui est une borne d'électrode de la première puce (2) et disposée sur la première surface interne (2a) ; et
un élément conducteur (9) disposé entre la première puce (2) et la seconde puce (3) pour connecter électriquement la deuxième borne (32) à la troisième borne (22).

5. Boîtier de semi-conducteur optique (1) selon l'une quelconque des revendications 1 à 3, comprenant en outre :
un second câblage (15) électriquement connecté à la deuxième borne (32), passant à travers l'intérieur de la première partie de résine (4a), et s'étendant du côté de la première surface interne vers le côté de la première surface externe dans la direction de face à face.

6. Boîtier de semi-conducteur optique (1) selon la revendication 5, dans lequel
une largeur de la première puce (2) est inférieure ou égale à une largeur de la seconde puce (3) dans une direction de largeur orthogonale à la direction de face à face.

7. Boîtier de semi-conducteur optique (1) selon la revendication 5, dans lequel
une largeur de la première puce (2) est inférieure à une largeur de la seconde puce (3) dans une direction de largeur orthogonale à la direction de face à face, et
le premier câblage (12) et le second câblage (15) sont disposés dans une région qui est, lorsqu'on regarde dans la direction de face à face, en chevauchement avec la seconde puce (3).

8. Boîtier de semi-conducteur optique (1) selon l'une quelconque des revendications 5 à 7, dans lequel
la seconde puce (3) est un premier élément de réception de lumière présentant une première partie de réception de lumière (31) qui reçoit une lumière incidente sur la seconde surface externe (3b), et
la première puce (2) est un second élément de réception de lumière présentant une seconde partie de réception de lumière (24) qui reçoit une lumière transmise à travers la seconde puce (3).

9. Procédé de production du boîtier de semi-conducteur optique (1) selon la revendication 4, le procédé comprenant ;
une première étape de formation d'une unité de substrat incluant un substrat (50) et une première électrode et une seconde électrode disposées sur le substrat (50) ;
une deuxième étape de formation d'une unité de puce incluant la première puce (2) et la seconde puce (3), l'unité de puce étant dans un état dans lequel la deuxième borne (32) et la troisième borne (22) sont électriquement connectées par l'élément conducteur (9) ;
une troisième étape de montage de l'unité de puce sur l'unité de substrat par liaison de la première surface externe (2b) à la première électrode ;
une quatrième étape de formation du premier câblage (12) par liaison par câbles de la première borne (21) et de la seconde électrode ;
une cinquième étape de formation d'un seul tenant de la première partie de résine (4a) et de la seconde partie de résine (4b) ; et
une sixième étape de retrait du substrat (50).

10. Procédé de production du boîtier de semi-conducteur optique (1) selon la revendication 4, le procédé comprenant :
une première étape de formation de la première puce (2) et de la première partie de résine (4a) dans laquelle une partie du premier câblage (12) est incorporée ;
une deuxième étape de formation d'une couche isolante (5) dotée du premier câblage (12) autour de la première borne (21) sur la première surface interne (2a) et sur la première partie de résine (4a) ;
une troisième étape de disposition de la seconde puce (3) sur la première puce (2) de sorte que la deuxième borne (32) et la troisième borne (22) soient électriquement connectées par l'élément conducteur (9) ; et
une quatrième étape de formation de la seconde partie de résine (4b) après la troisième étape.

11. Procédé de production du boîtier de semi-conducteur optique (1) selon la revendication 5, le procédé comprenant :
une première étape de formation de la première puce (2) et de la première partie de résine (4a) dans laquelle une partie du premier câblage (12) et du second câblage (15) est incorporée ;
une deuxième étape de formation d'une couche isolante (5) dotée du premier câblage (12) et du second câblage (15), sur la première surface interne (2a) et la première partie de résine (4a) ;
une troisième étape de disposition de la seconde puce (3) sur la couche isolante (5) de sorte qu'une partie d'extrémité du second câblage (15) et la deuxième borne (32) soient électriquement connectées ; et
une quatrième étape de formation de la seconde partie de résine (4b) après la troisième étape.

12. Procédé de production du boîtier de semi-conducteur optique (1) selon la revendication 4, le procédé comprenant :
une première étape de formation d'un substrat (50), la première puce (2) étant disposée sur le substrat (50) de sorte que la première surface externe (2b) fasse face au substrat (50), la première partie de résine (4a) étant formée pour recouvrir la première surface interne (2a) et la première surface latérale (2c), et le premier câblage (12) et l'élément conducteur (9) étant disposés sur la première partie de résine (4a) et à l'intérieur de la première partie de résine (4a) ;
une deuxième étape de formation d'une couche isolante (5) dans laquelle une ouverture permettant d'exposer l'élément conducteur (9) est fournie, sur la première partie de résine (4a), pour recouvrir le premier câblage (12) et l'élément conducteur (9) ;
une troisième étape de disposition de la seconde puce (3) sur la couche isolante (5) de sorte que la deuxième borne (32) et l'élément conducteur (9) soient électriquement connectés via l'ouverture de la couche isolante (5) ;
une quatrième étape de formation de la seconde partie de résine (4b) après la troisième étape ; et
une cinquième étape de décollage du substrat (50) de la première puce (2) et de la première partie de résine (4a).

13. Procédé de production du boîtier de semi-conducteur optique (1) selon la revendication 4, le procédé comprenant :
une première étape de formation d'un substrat (50), une seconde puce (3) étant disposée sur le substrat (50) de sorte que la seconde surface externe (3b) fasse face au substrat (50), la seconde partie de résine (4b) étant formée pour recouvrir la seconde surface interne (3a) et la seconde surface latérale (3c), et une première partie du premier câblage (12) et l'élément conducteur (9) étant disposés sur la seconde partie de résine (4b) et à l'intérieur de la seconde partie de résine (4b) ;
une deuxième étape de formation d'une couche isolante (5) dans laquelle une première ouverture (13e) et une deuxième ouverture (13d) permettant d'établir un contact avec la première partie et une troisième ouverture (13c) permettant d'établir un contact avec l'élément conducteur (9) sont fournies, sur la seconde partie de résine (4b), pour recouvrir la première partie et l'élément conducteur (9) ;
une troisième étape de formation d'une seconde partie du premier câblage (12) électriquement connectée à la première partie via la première ouverture (13e) sur la couche isolante (5) ;
une quatrième étape de disposition de la première puce (2) sur la couche isolante (5) de sorte que la première borne (21) et la première partie soient électriquement connectées via la deuxième ouverture (13d) et de sorte que la troisième borne (22) et l'élément conducteur (9) soient électriquement connectés via la troisième ouverture (13c) ;
une cinquième étape de formation de la première partie de résine (4a) après la quatrième étape ; et
une sixième étape de décollage du substrat (50) de la seconde puce (3) et de la seconde partie de résine (4b).

14. Procédé de production du boîtier de semi-conducteur optique (1) selon l'une quelconque des revendications 9 à 13, dans lequel
la seconde partie de résine (4b) est formée de manière à ne pas recouvrir la seconde surface externe (3b).

15. Procédé de production du boîtier de semi-conducteur optique (1) selon la revendication 14, comprenant en outre :
une étape d'élimination d'une partie située sur le côté de la seconde surface externe de la seconde puce (3) de sorte que la seconde surface externe (3b) soit positionnée plus près de la première puce (2) qu'une surface de la seconde partie de résine (4b) sur un côté opposé à la première partie de résine (4a).
